(19) Europäisches Patentamt
European Patent Office
Office européen des brevets

(11) **EP 3 531 458 B1**

(12) **EUROPÄISCHE PATENTSCHRIFT**

(45) Veröffentlichungstag und Bekanntmachung des Hinweises auf die Patenterteilung:
**09.09.2020   Patentblatt 2020/37**

(51) Int Cl.:
*H01L 31/02* *(2006.01)*          *H01L 31/048* *(2014.01)*
*H01L 31/18* *(2006.01)*

(21) Anmeldenummer: **18158484.8**

(22) Anmeldetag: **23.02.2018**

(54) **SOLARMODUL MIT HOMOGENEM FARBEINDRUCK**

SOLAR MODULE WITH HOMOGENEOUS COLOUR EFFECT

MODULE SOLAIRE À EFFET CHROMATIQUE HOMOGÈNE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.08.2019   Patentblatt 2019/35**

(73) Patentinhaber: **(CNBM) Bengbu Design & Research Institute for Glass Industry Co., Ltd.**
**233010 Bengbu (CN)**

(72) Erfinder: **PALM, Jörg**
**80797 München (DE)**

(74) Vertreter: **Gebauer, Dieter Edmund**
**Splanemann**
**Patentanwälte Partnerschaft**
**Rumfordstraße 7**
**80469 München (DE)**

(56) Entgegenhaltungen:
**WO-A1-2007/071703          CH-A5- 678 466**
**DE-A1- 10 349 269          US-A1- 2002 153 038**
**US-A1- 2016 049 904**

**Beschreibung**

Die vorliegende Erfindung liegt auf dem technischen Gebiet der photovoltaischen Energieerzeugung und betrifft ein Solarmodul mit homogenem Farbeindruck. Die Erfindung erstreckt sich weiterhin auf ein Verfahren zur Herstellung des erfindungsgemäßen Solarmoduls sowie dessen Verwendung.

In Freiflächenanlagen kann ein großer Zuwachs an Solarmodulen beobachtet werden, jedoch bewegen sich Anwendungen im gebäudeintegrierten Umfeld derzeit noch in weit kleinerem Rahmen. Angesichts verstärkter Bemühungen für dezentrale Energielösungen entsteht ein konkreter Bedarf für die Anwendung von Solarmodulen als integrierte Bestandteile von Gebäudehüllen, beispielsweise als Fassadenelemente, Fenster oder Dachelemente. Weitere Anwendungsbereiche für Solarmodule sind Lärmschutzwände (Straße, Schiene), Sichtschutzwände im Außenbereich oder Wände für Gewächshäuser. Diese neue Anwendung stellt völlig neue Anforderungen an Solarmodule, insbesondere im Hinblick auf Ästhetik, Lebensdauer und weitere Funktionalitäten wie Abdichtung und Wärmeisolation. Insbesondere sollen Solarmodule in verschiedenen Formen, Größen und Farben zur Verfügung stehen und einen möglichst homogenen Farbeindruck vermitteln. Hierbei gibt es jedoch technische Probleme, die mit der eigentlichen Funktionalität der Solarmodule, nämlich der Generation von elektrischer Leistung aus dem Sonnenlicht, in Konflikt stehen.

Ein ideales Solarmodul wäre hinsichtlich Wirkungsgradoptimierung ein schwarzer Körper, der die auftreffende elektromagnetische Strahlung vollständig absorbiert, um die einfallende Strahlungsenergie optimal in elektrische Energie umzuwandeln. Jedoch wird von jedem realen Körper auftreffende Strahlung reflektiert und absorbierte Strahlung remittiert, wobei der Farbeindruck im menschlichen Auge grundsätzlich aus der spektral selektierten Reflexion und der Remission von sichtbarem Licht entsteht. Das Sonnenspektrum hat im sichtbaren Spektralbereich die höchste Energieintensität und das menschliche Auge die größte Empfindlichkeit. Wird ein Solarmodul farbig gestaltet, d.h. soll im menschlichen Auge ein Farbeindruck erzeugt werden, der vom idealen schwarzen Körper verschieden ist, reduziert man zwingend die Intensität des im optisch aktiven Halbleiter absorbierten Lichts und damit die elektrische Leistung bzw. den Wirkungsgrad des Solarmoduls.

Andererseits hat ein Solarmodul konstruktionsbedingt in aller Regel auf der zum einfallenden Licht zugewandten Seite keine optisch homogene Fläche, d.h. die Oberfläche des Solarmoduls vermittelt keinen homogenen Farbeindruck. So sieht man bei Siliziumwafermodulen die Wafer, die Busbars, oft einen Rahmen und die Fläche zwischen den Wafern. Im Unterschied hierzu sind Dünnschichtsolarmodule typischer Weise gleichmäßiger im Farbeindruck, jedoch gibt es besonders im Randbereich des Dünnschichtsolarmoduls technologisch bedingte Details, wie metallische Busbars, eine Randentschichtung und/oder Randversiegelung, die vom Farbeindruck der optisch aktiven Flächen abweichen können. Zudem sind die Strukturierungslinien der monolithisch serienverschalteten Solarzellen zu erkennen. Bei Dünnschichtsolarmodulen ist der optisch aktive Zellbereich meist schwarz, anthrazitgrau oder mit Restfarbtönen von dunklen Blau- und Grüntönen versehen. Bei Siliziumwafermodulen ist der optisch aktive Zellbereich meist blau.

Zur Lösung dieses Problems zeigt die WO 2007/071703 A1 ein Dünnschichtsolarmodul, bei dem im Randbereich eine opake Abdeckung des Frontglases vorgesehen ist. Die Abdeckung ist durch eine auf das Frontglas aufgetragene Farbe, eine im Siebdruck aufgebrachte Farbe oder eine Modifikation des Frontglases, beispielsweise durch ein Pigment, realisiert. Möglich ist auch die Abdeckung durch ein auf das Frontglas aufgebrachtes Band. Zwar werden durch die opake Abdeckung die verschiedenen Strukturen im Randbereich zufriedenstellend abgedeckt, jedoch ist ein homogener Farbeindruck über das komplette Solarmodul hinweg nicht gegeben, da in aller Regel der Farbeindruck der optisch aktiven Flächen von der Farbe der Abdeckung abweicht und somit ein starker Kontrast zum Randbereich gegeben ist.

Weiterhin sind im Stand der Technik verschiedene Verfahren bekannt, um einer Oberfläche eine bestimmte Farbe zu vermitteln. So zeigt beispielsweise die WO 2014/045142 A1 eine Vorrichtung, bei der Interferenzschichten auf einem Frontglas ausgebildet sind, welche einen bestimmten Spektralbereich des einfallenden Lichts reflektieren. Jedoch ist die Herstellung solcher Schichten technisch aufwendig und teuer. Aus der WO 2011/036209 A1 ist die farbige Gestaltung der Frontelektrode durch geeignete Interferenzschichten bekannt. Diesen Ansätzen ist gemein, dass sie eine gewisse Richtungsabhängigkeit des Farbeindrucks zeigen. Zudem ist ein Kontrast zwischen photovoltaisch aktiven und inaktiven Zonen deutlich erkennbar. Weiterhin ist nur eine begrenzte Auswahl an Farben verfügbar.

Die CH678466 A5 offenbart ein Solarmodul, wobei die Stellen der Abdeckung, hinter denen je eine der Solarzellen ist, eine solche Farbe haben, dass sie für den photo-elektrisch wirksamen Teil der Sonnenstrahlung durchlässig sind, und der restliche Flächenteil der Abdeckung eine derartige Farbe, dass das sichtbare Licht an den Stellen, an denen die Solarzellen hinter der Abdeckung sind, ebenso wie am restlichen Flächenteil der Abdeckung reflektiert wird. Die Färbungen der Abdeckung erfolgt durch Farbbeschichtungen.

Die DE 103 49 269 zeigt eine Photovoltaik-Glasscheibe umfassend ein Photovoltaikmodul wobei das Photovoltaikmodul eine Unterseite und eine Lichtseite aufweist und auf der Lichtseite des Photovoltaikmoduls dieses von einer licht- oder strahlungsdurchlässigen Abdeckung überdeckt ist, und wobei an der Unterseite eine Träger- und/oder Schutzschicht vorgesehen ist und die Abdeckung eine Beschichtung und/ oder Bedruckung aufweist.

Demgegenüber besteht die Aufgabe der vorliegenden Erfindung darin, im Stand der Technik bekannte Solarmodule in vorteilhafter Weise mit einem homogenen Farbeindruck über das komplette Modul hinweg zu versehen, wobei insbesondere kein starker Kontrast zwischen optisch aktiven und optisch inaktiven Flächen vorliegen soll. Der homogene Farbeindruck soll bei möglichst minimiertem Wirkungsgradverlust und geringer Richtungsabhängigkeit realisierbar sein. Zudem sollen die Solarmodule in der industriellen Serienfertigung mit gängigen Verfahren kostengünstig und effizient herstellbar sein.

Diese und weitere Aufgaben werden nach dem Vorschlag der Erfindung durch ein Solarmodul und ein Verfahren zu dessen Herstellung gemäß den nebengeordneten Patentansprüchen gelöst. Vorteilhafte Ausgestaltungen der Erfindung sind durch die Merkmale der Unteransprüche angegeben.

Erfindungsgemäß ist ein Solarmodul mit elektrisch in Serie verschalteten Solarzellen zur photovoltaischen Energieerzeugung gezeigt. Grundsätzlich kann es sich bei dem erfindungsgemäßen Solarmodul um jede Art von Solarmodul handeln, insbesondere um ein Silizium-basiertes Solarmodul auf Wafer-Basis oder ein Dünnschichtsolarmodul mit in monolithisch integrierter Form serienverschalteten Solarzellen.

Vorzugsweise ist das erfindungsgemäße Solarmodul ein Dünnschichtsolarmodul. Vorteilhaft handelt es sich bei dem Solarmodul um ein Dünnschichtsolarmodul mit Verbundscheibenstruktur, welches über eine frontseitige Abdeckung und rückseitiges Substrat (z.B. Glasplatten) verfügt, die durch eine thermoplastische Zwischenschicht (z.B. PVB-Schicht) fest miteinander verbunden sind. Die Erfindung bezieht sich auf ein Dünnschichtsolarmodul in Substratkonfiguration, bei der der Schichtenaufbau zur Herstellung der Solarzellen auf einer der Lichteintrittsseite zugewandten Oberfläche eines rückseitigen Substrats aufgebracht ist. Die Erfindung bezieht sich gleichermaßen auf ein Dünnschichtsolarmodul in Superstratkonfiguration, bei welcher der Schichtenaufbau auf einer von der Lichteintrittsseite abgewandten Oberfläche einer frontseitigen (transparenten) Abdeckung aufgebracht ist.

In Einklang mit der üblichen Verwendung bezieht sich der Begriff "Dünnschichtsolarmodul" auf Module mit einem Schichtenaufbau mit einer geringen Dicke von beispielsweise einigen Mikrometern, welche ein Substrat für eine ausreichende mechanische Festigkeit benötigen. Das Substrat kann beispielsweise aus anorganischem Glas, Kunststoff, Metall oder einer Metalllegierung bestehen und kann in Abhängigkeit von der jeweiligen Schichtdicke und den spezifischen Materialeigenschaften als starre Platte oder biegsame Folie ausgestaltet sein.

In seiner Ausgestaltung als Dünnschichtsolarmodul umfasst der Schichtenaufbau in an sich bekannter Weise eine Rückelektrodenschicht, eine Frontelektrodenschicht, und eine zwischen Rück- und Frontelektrodenschicht angeordnete, photovoltaisch aktive Absorberschicht. Die Frontelektrodenschicht ist optisch transparent, da ein Durchtritt von Licht zum Schichtenaufbau ermöglicht sein muss. Die optisch transparente Frontelektrodenschicht umfasst oder besteht typischer Weise aus einem dotierten Metalloxid (TCO = Transparent Conductive Oxide), beispielsweise n-leitendes, insbesondere Aluminium-dotiertes, Zinkoxid (AZO).

Vorzugsweise umfasst oder besteht die photovoltaisch aktive Absorberschicht aus einem Chalkopyrit-Halbleiter, bei dem es sich vorteilhaft um einen ternären I-III-VI-Verbindungshalbleiter aus der Gruppe Kupfer-Indium/Gallium-Disulfid/Diselenid ($Cu(In,Ga)(S,Se)_2$) handelt. In vorstehender Formel können Indium und Gallium jeweils allein oder in Kombination vorliegen. Entsprechendes gilt für Schwefel und Selen, die jeweils allein oder in Kombination vorliegen können. Als Material für die Absorberschicht eignet sich in besonderer Weise CIS (Kupferindiumdiselenid/-disulfid) oder CIGS (Kupferindiumgalliumdiselenid, Kupferindiumgalliumdisulfid, Kupferindiumgalliumdisulfoselenid). Die Absorberschicht weist typischer Weise eine Dotierung von einem ersten Leitungstyp (Ladungsträgertyp) und die Frontelektrode eine Dotierung vom entgegengesetzten Leitungstyp (Ladungsträgertyp) auf. In aller Regel ist die Absorberschicht p-leitend (p-dotiert), verfügt also über einen Überschuß von Defektelektronen (Löcher) und die Frontelektrodenschicht ist n-leitend (n-dotiert), so dass freie Elektronen in Überschuß vorhanden sind. Zwischen Absorberschicht und Frontelektrodenschicht ist typischer Weise eine Pufferschicht angeordnet. Dies gilt insbesondere für Absorberschichten auf Basis von $Cu(In,Ga)(S,Se)_2$, bei denen in aller Regel eine Pufferschicht zwischen einer p-leitenden $Cu(In,Ga)(S,Se)_2$-Absorberschicht und einer n-leitenden Frontelektrode benötigt wird. Nach derzeitiger Erkenntnis ermöglicht die Pufferschicht eine elektronische Anpassung zwischen Absorber und Frontelektrode. Sie bietet außerdem einen Schutz vor Sputterschäden in einem nachfolgenden Prozeßschritt der Abscheidung der Frontelektrode beispielsweise durch DC-Magnetron-Sputtern. Durch die Abfolge aus n-leitender Frontelektrodenschicht, Pufferschicht und p-leitender Absorberschicht wird ein p-n-Heteroübergang gebildet, das heißt ein Übergang zwischen Schichten vom entgegengesetzten Leitungstyp. Die photovoltaisch aktive Absorberschicht kann beispielsweise auch aus Cadmiumtellerid (CdTe) bestehen.

Im erfindungsgemäßen Dünnschichtsolarmodul sind durch Strukturierungszonen serienverschaltete Solarzellen ausgebildet. So ist mindestens die Rückelektrodenschicht durch erste Strukturierungslinien (P1-Linien) in vollständig voneinander getrennte Abschnitte unterteilt, welche die Rückelektroden der Solarzellen bilden. Ferner ist mindestens die Absorberschicht durch zweite Strukturierungslinien (P2-Linien) in vollständig voneinander getrennte Abschnitte unterteilt, welche die Absorber der Solarzellen bilden, und mindestens die Frontelektrodenschicht ist durch dritte Strukturierungslinien (P3-Linien) in vollständig voneinander getrennte Abschnitte unterteilt, welche die Frontelektroden der Solarzellen bilden. Benachbarte Solarzellen sind über elektrisch leitfähiges Material in den zweiten Strukturierungslinien in Serienverschaltung elektrisch miteinander verbunden, wobei die Frontelektrode einer Solarzelle mit der Rückelektrode der benachbarten Solarzelle elektrisch verbunden ist und mit dieser typischer Weise, jedoch nicht zwingend, direkten Berührungskontakt hat. Jede Strukturierungszone umfasst eine unmittelbare Abfolge der drei Strukturierungslinien P1-P2-P3, jeweils in dieser Reihenfolge. Jede Strukturierungszone ist eine optisch inaktive Zone.

In Einklang mit der gängigen Verwendung bezieht sich der Begriff "Solarzelle" auf einen Bereich des Schichtenaufbaus, der eine Frontelektrode, einen photovoltaisch aktiven Absorber und eine Rückelektrode aufweist und von zwei einander unmittelbar benachbarten Strukturierungszonen begrenzt wird. Im Randbereich des Moduls gilt dies analog, wobei anstelle einer Strukturierungszone ein Anschlußabschnitt für eine elektrische Kontaktierung der Serienverschaltung der Solarzellen vorhanden ist, so dass die Solarzelle durch den Schichtenbereich mit Frontelektrode, Absorber und Rückelektrode definiert ist, der sich zwischen einer Strukturierungszone und dem unmittelbar angrenzenden Anschlußabschnitt befindet. Jede Solarzelle weist eine optisch aktive Zone auf, die, stapelförmig übereinander angeordnet, eine Rückelektrode, einen Absorber und eine Frontelektrode umfasst und zur photoelektrischen Konversion von Licht in elektrischen Strom fähig ist.

Das erfindungsgemäße Solarmodul weist einen Innenbereich, welcher die Solarzellen mit optisch aktiven Zellflächen und optisch inaktiven Strukturierungszonen umfasst, und einen optisch inaktiven Randbereich, der den Innenbereich umgibt, auf. Im Randbereich ist der Schichtenaufbau typischer Weise entfernt oder nicht abgeschieden. Zudem befindet sich dort in aller Regel eine Randversiegelung sowie metallische Sammelleiter (Busbars) zur elektrischen Kontaktierung der Solarzellen.

Das erfindungsgemäße Solarmodul umfasst jedenfalls eine lichteintrittsseitige bzw. frontseitige transparente Abdeckung, insbesondere eine plattenförmige starre Abdeckung, vorzugsweise eine starre Glasplatte. Die frontseitige Abdeckung weist in Form einer starren Platte keine Krümmung auf und ist plan (eben). In Form einer biegsamen Abdeckung kann sie in ebener Form bereitgestellt werden. Die frontseitige Abdeckung weist eine der äußeren Umgebung zugewandte Außenfläche und eine den Solarzellen zugewandte Innenfläche auf.

Im Sinne vorliegender Erfindung bezieht sich der Begriff "Transparenz" bzw. "transparent" auf eine Durchlässigkeit für sichtbares Licht von wenigstens 85%, insbesondere wenigstens 90%, vorzugsweise wenigstens 95%, insbesondere 100%. Typischer Weise liegt sichtbares Licht im Wellenlängenbereich von 380 nm bis 780 nm vor. Der Begriff "Opazität" bzw. "opak" bezieht sich auf eine Durchlässigkeit für sichtbares Licht von weniger als 5%, insbesondere 0%. Die prozentualen Angaben beziehen sich auf die Intensität des Lichts, gemessen modulinnenseitig der frontseitigen Abdeckung, bezogen auf die Intensität des auf die frontseitige Abdeckung von der äußeren Umgebung her auftreffenden Lichts. Die Transparenz des Abdeckung kann in einfacher Weise durch eine Meßanordnung bestimmt werden, bei der beispielsweise eine Weißlichtquelle (Quelle für sichtbares Licht) auf einer Seite der frontseitigen Abdeckung und ein Detektor für sichtbares Licht auf der anderen Seite der frontseitigen Abdeckung angeordnet werden.

Das erfindungsgemäße Solarmodul umfasst optisch aktive Zonen (Zellflächen), welche einfallendes Licht absorbieren und (photo-)elektrischen Strom erzeugen können, sowie optisch inaktive Zonen, die zur Absorption von einfallendem Licht und Erzeugung von (Photo-)Elektronen nicht in der Lage sind. Optisch inaktiv ist insbesondere der Randbereich des Solarmoduls sowie bei Dünnschichtsolarzellen die Strukturierungszonen zur integrierten Serienverschaltung der Solarzellen. Bei Siliziumwafermodulen ist insbesondere der Bereich zwischen den Wafern optisch inaktiv.

Das erfindungsgemäße Solarmodul weist wenigstens zwei voneinander verschiedene Farben auf. Die optisch aktiven Zonen der Solarzellen (Zellflächen) haben typischer Weise eine im Wesentlichen gleiche Farbe, welche eine erste Farbe $F_1$ mit den Farbkoordinaten $L^*_1$, $a^*_1$, $b^*_1$ ist. Der Index "1" in den Farbkoordinaten bezeichnet die erste Farbe $F_1$. Die optisch inaktiven Zonen haben mindestens eine von der ersten Farbe $F_1$ verschiedene zweite Farbe $F_2$ mit den Farbkoordinaten $L^*_2$, $a^*_2$, $b^*_2$. Die optisch inaktiven Zonen können insbesondere mehrere voneinander verschiedene Farben aufweisen, die jeweils von der ersten Farbe $F_1$ verschieden sind. Der Index "2" in den Farbkoordinaten bezeichnet die zweite Farbe $F_2$.

Wie hier und im Weiteren verwendet, beziehen sich die Farbkoordinaten der Farben auf den dem Fachmann an sich bekannten (CIE)L*a*b*-Farbraum, in dem alle wahrnehmbaren Farben exakt definiert sind. Der Farbraum ist in der europäischen Norm EN ISO 11664-4 "Colorimetry - Part 4:CIE 1976 L*a*b* Colour space" spezifiziert. Auf diese Norm wird hier vollumfänglich Bezug genommen. In diesem Farbraum ist jede Farbe durch einen Farbort mit den drei kartesischen Koordinaten L*, a*, b* definiert. Auf der a*-Achse liegen sich Grün und Rot gegenüber, die b*-Achse verläuft zwischen Blau und Gelb, die L*-Achse beschreibt die Helligkeit (Luminanz) der Farbe.

Die Angabe der ersten Farbe $F_1$ der optisch aktiven Zonen sowie die Angabe der mindestens einen zweiten Farbe $F_2$ der optisch inaktiven Zonen beziehen sich jeweils auf eine Betrachtung von Seiten der äußeren Umgebung her, d.h. in Sicht durch die lichteintrittsseitige (frontseitige) transparente Abdeckung hindurch. Somit beziehen sich die Farbangaben auf die jeweilige Farbe welche an der Außenfläche der lichteintrittsseitigen Abdeckung gegeben ist. Die Farbmessung bzw. die Bestimmung der Farbkoordinaten einer Farbe kann in einfacher Weise durch ein im Handel verfügbares Farbmeßgerät (Spektralphotometer) erfolgen, wobei ein und dasselbe Gerät für die Farbmessung verwendet wird. Das Farbmeßgerät wird zu diesem Zweck auf die Außenfläche der lichteintrittsseitigen Abdeckung gerichtet, insbesondere auf die Außenfläche aufgesetzt. Übliche Farbmeßgeräte ermöglichen eine normgerechte Farbmessung, wobei deren Aufbau und Toleranzen typischer Weise internationalen Normen unterliegen, beispielsweise definiert durch DIN 5033, ISO/CIE 10527, ISO 7724 und ASTM E1347. Beispielsweise wird hinsichtlich der Farbmessung auf die Norm DIN 5033 vollumfänglich Bezug genommen. Ein Farbmeßgerät weist als Lichtquelle beispielsweise eine Xenon-Blitzlampe, Wolfram-Halogenlampe oder ein oder mehrere LEDs auf, wobei die Außenfläche eines Körpers mit dem erzeugten (z.B. Weiß-)Licht beleuchtet und das vom Solarmodul empfangene Licht gemessen wird. Wie eingangs erläutert, ergibt sich die vom Farbmeßgerät gemessene Körperfarbe aus dem reflektierten und remittierten Licht.

In dem erfindungsgemäßen Solarmodul, weist die frontseitige Abdeckung auf ihrer Außen- und/oder Innenfläche mindestens ein erstes Punktraster auf, welches (in senkrechter Sicht auf die frontseitige Abdeckung) mindestens die optisch aktiven Zonen (vollständig) überdeckt. Für die Betrachtung der Überdeckung können die optisch aktiven Zonen in die Ebene der (planen) frontseitigen Abdeckung (senkrecht) projiziert werden. Die optisch aktiven Zonen der Solarzellen bzw. der Innenbereich des Solarmoduls können von einem einzigen ersten Punktraster (vollständig) überdeckt sein, wobei sich das erste Punktraster insbesondere auch über optisch inaktive Zonen (Strukturierungszonen bei Dünnschichtsolarmodulen oder Bereiche zwischen Wafern bei Siliziumwafermodulen) zwischen den optisch aktiven Zonen erstrecken kann. Möglich ist auch, dass jede optisch aktive Zone von einem separaten ersten Punktraster (vollständig) überdeckt wird. In diesem Fall weist das Solarmodul eine Mehrzahl erster Punktraster auf. In einer Ausgestaltung der Erfindung überdeckt ein jeweiliges erstes Punktraster exakt eine optisch aktive Zone, d.h. Form und Abmessungen des ersten Punktrasters sind mit jenen der optischen aktiven Zone identisch. Falls lediglich ein einziges erster Punktraster vorgesehen ist, das den Innenbereich des Solarmoduls überdeckt, ist möglich, dass Form und Abmessungen des ersten Punktrasters jenen des Innenbereichs des Solarmoduls entsprechen.

Das mindestens eine erste Punktraster, bzw. jedes erste Punktraster, weist eine Vielzahl opaker Farbpunkte auf, die jeweils eine von der ersten Farbe $F_1$ der optisch aktiven Zone verschiedene dritte Farbe $F_3$ mit den Farbkoordinaten $L^*_3$, $a^*_3$, $b^*_3$ haben.

In dem erfindungsgemäßen Solarmodul, weist die lichteintrittsseitige Abdeckung auf ihrer Außen- und/oder Innenfläche mindestens ein zweites Punktraster auf, welches mindestens eine optisch inaktive Zone (vollständig) überdeckt. Beispielsweise weist das Solarmodul ein zweites Punktraster auf, welches den optisch inaktiven Randbereich des Solarmoduls (vollständig) überdeckt. In einer Ausgestaltung der Erfindung überdeckt das zweite Punktraster genau den optisch inaktiven Randbereich des Solarmoduls, d.h. Form und Abmessungen des zweiten Punktrasters sind mit jenen des Randbereichs identisch. Ergänzend oder alternativ kann das Solarmodul eine Mehrzahl zweiter Punktraster aufweisen, wobei jeder optisch inaktive Zwischenbereich zwischen den Solarzellen (Strukturierungszonen oder Bereiche zwischen Wafern bei Siliziumwafermodulen) jeweils von einem separaten zweiten Punktraster (vollständig) überdeckt ist. In einer Ausgestaltung der Erfindung befindet sich jedes zweite Punktraster genau in Überdeckung zum optisch inaktiven Zwischenbereich des Solarmoduls, d.h. Form und Abmessungen des zweiten Punktrasters sind mit jenen des optischen inaktiven Zwischenbereichs identisch. Weitere optisch inaktive Bereiche sind Kontaktbänder oder die Randentschichtungszone oder Randversiegelungen bei Dünnschichtsolarmodulen.

Das mindestens eine zweite Punktraster, bzw. jedes zweite Punktraster, weist eine Vielzahl opaker Farbpunkte auf, die jeweils eine von der zweiten Farbe $F_2$ verschiedene vierte Farbe $F_4$ mit den Farbkoordinaten $L^*_4$, $a^*_4$, $b^*_4$ haben.

Im Sinne vorliegender Erfindung bezieht sich der Begriff "Punktraster" auf eine Anordnung einer Vielzahl opaker Farbpunkte. Einander unmittelbar benachbarte Punkte weisen einen Zwischenabstand auf. Die Anordnung der Farbpunkte im Punktraster ist vorzugsweise gleichmäßig, d.h. einander unmittelbar benachbarte Farbpunkte haben einen gleichen Zwischenabstand. Der Zwischenabstand einander unmittelbar benachbarter Farbpunkte kann von Null verschieden sein, wobei in diesem Fall das Punktraster auch transparente Stellen (der Abdeckung) zwischen den opaken Farbpunkten umfasst. In den transparenten Stellen zwischen den opaken Farbpunkten ist die darunter liegende Struktur durch die transparente Abdeckung hindurch erkennbar, d.h. die optisch aktiven Zonen sind im Bereich des mindestens einen ersten Punktrasters sowie die optisch inaktiven Zonen im Bereich des mindestens einen zweiten Punktrasters erkennbar. Die Abdeckung erlangt hierdurch eine Semitransparenz. Obgleich hier der Begriff "Punkt" für ein einzelnes opakes Farbelement des Punktrasters gewählt ist, ist die Form eines Farbpunktes nicht auf eine kreisrunde Form eingeschränkt. Vielmehr kann ein opaker Farbpunkt im Punktraster grundsätzlich jede beliebige Form haben und beispielsweise scheibenförmig, quadratisch oder rechteckig sein. Der Begriff "Punktraster" umfasst im Sinne der Erfindung insbesondere auch den Fall, dass ein Zwischenabstand zwischen unmittelbar benachbarten opaken Farbpunkten Null ist, d.h. einen vollflächigen Farbauftrag, bei dem opake Farbpunkte nicht mehr individualisierbar sind. Ein vollflächiger Farbauftrag kann beispielsweise auch durch Aufstreichen auf eine Oberfläche der lichteintrittsseitigen Abdeckung aufgebracht werden.

Das mindestens eine erste und/oder mindestens eine zweite Punktraster kann durch eine herkömmliche Auftragstechnik, beispielsweise im Siebdruck- oder Digitaldruckverfahren, auf die Außenfläche und/oder Innenfläche der lichteintrittsseitigen Abdeckung aufgebracht werden. Dem Fachmann ist das Aufbringen eines Punktrasters auf eine Oberfläche wohlbekannt, so dass hier nicht näher darauf eingegangen werden muss. Vorzugsweise sind das mindestens eine erste und/oder mindestens eine zweite Punktraster auf die Innenfläche der lichteintrittsseitigen Abdeckung aufgebracht, wodurch es vor äußeren Einwirkungen, beispielsweise durch witterungsbedingten mechanischen Abtrag, Staub und Schmutz geschützt ist.

In dem mindestens einen ersten Punktraster, welches mindestens eine optisch aktive Zone überdeckt, ist der Zwischenabstand zwischen unmittelbar benachbarten Farbpunkten stets von Null verschieden, so dass im Bereich des ersten Punktrasters opake Bereiche (opake Farbpunkte des ersten Punktrasters) und optisch transparente Bereiche (Zwischenbereiche zwischen den opaken Farbpunkten des Punktrasters) der Abdeckung vorliegen. Demnach addieren (kombinieren) sich im ersten Punktraster die erste Farbe $F_1$ der optisch aktiven Zonen und die dritte Farbe $F_3$ der opaken Punkte des ersten Punktrasters, so dass sich im Bereich des ersten Punktrasters durch Addition der ersten Farbe $F_1$ und der dritten Farbe $F_3$ eine Additionsfarbe (Kombinationsfarbe) $F_1$' mit den Farbkoordinaten $L*_1$', $a*_1$', $b*_1$' ergibt. Hierbei wird eine Addition (Kombination) der beiden Farben $F_1$ und $F_3$ in einem Bereich des ersten Punktrasters betrachtet, der mindestens 0,2 cm$^2$, insbesondere mindestens 0,5 cm$^2$, insbesondere mindestens 1 cm$^2$ groß ist. Im menschlichen Auge bzw. Farbmeßgerät wird bei anwendungstypischem Abstand zwischen Betrachter und Modul von ein oder mehreren Metern durch die additive Farbmischung der beiden Farben $F_1$ und $F_3$ ein Farbeindruck erfasst, der typischer Weise einer gemittelten Additionsfarbe $F_1$' entspricht. Im Sinne vorliegender Erfindung beziehen sich die Begriffe "Addition" bzw. "Kombination" von Farben auf den Gesamteindruck im menschlichen Auge oder einem Farbmeßgerät, wenn die Farben von einer Außenfläche des Moduls von mindestens 0,2 cm$^2$ betrachtet werden.

Gemäß einer Ausgestaltung des erfindungsgemäßen Solarmoduls ist in dem mindestens einen zweiten Punktraster der Zwischenabstand zwischen unmittelbar benachbarten Punkten von Null verschieden, so dass auch im Bereich des zweiten Punktrasters opake Bereiche (opake Farbpunkte des zweiten Punktrasters) und optisch transparente Bereiche (Zwischenbereiche zwischen den opaken Farbpunkten des zweiten Punktrasters) der frontseitigen Abdeckung vorliegen. Demnach addieren (kombinieren) sich im zweiten Punktraster bei anwendungstypischen Abstand zwischen Betrachter und Modul von ein oder mehreren Metern die mindestens eine zweite Farbe $F_2$ der optisch inaktiven Bereiche und die vierte Farbe $F_4$ der opaken Farbpunkte des zweiten Punktrasters, so dass sich im Bereich des zweiten Punktrasters durch Addition der zweiten Farbe $F_2$ und der vierten Farbe $F_4$ eine Additionsfarbe (Kombinationsfarbe) $F_2$' mit den Farbkoordinaten $L*_2$', $a*_2$', $b*_2$' ergibt. Auch für das zweite Punkraster wird eine Addition (Kombination) der Farben $F_2$ und $F_4$ in einem Bereich des zweiten Punktrasters betrachtet, der beispielsweise mindestens 0,2 cm$^2$, insbesondere mindestens 0,5 cm$^2$, insbesondere mindestens 1 cm$^2$ groß ist. Im menschlichen Auge bzw. Farbmeßgerät wird bei anwendungstypischem Abstand zwischen Betrachter und Modul von ein oder mehreren Metern durch die additive Farbmischung der beiden Farben $F_2$ und $F_4$ ein Farbeindruck erfasst, der typischer Weise einer gemittelten Farbe $F_2$' entspricht.

Analog zur ersten Farbe $F_1$ der optisch aktiven Zonen sowie der mindestens einen zweiten Farbe $F_2$ der optisch inaktiven Zonen beziehen sich die Additionsfarben $F_1$' und $F_2$' jeweils auf eine Betrachtung der frontseitigen Oberfläche des Solarmoduls von der äußeren Umgebung her. Falls das mindestens eine erste Punktraster und das mindestens eine zweite Punktraster auf die Innenfläche der frontseitigen Abdeckung aufgebracht ist, beziehen sich die Angaben der dritten Farbe F3 und vierte Farbe F4 jeweils auf die Farbe in Sicht durch die frontseitige Abdeckung hindurch, also die Farbe, welche an der Außenfläche des frontseitigen Abdeckung vorliegt. In entsprechender Weise beziehen sich die Additionsfarben $F_1$' und $F_2$' jeweils auf die Farbe, welche an der Au-ßenfläche der frontseitigen Abdeckung vorliegt. Wie bereits für die Farben $F_1$ und $F_2$ ausgeführt, können die Farbkoordinaten der Additionsfarben $F_1$' und $F_2$' durch ein im Handel verfügbares Farbmeßgerät (Spektralphotometer) bestimmt werden. Das Farbmeßgerät wird zu diesem Zweck senkrecht auf die Außenfläche der lichteintrittsseitigen Abdeckung gerichtet und insbesondere auf die Außenfläche des lichteintrittsseitigen Substrats aufgesetzt.

Wesentlich hierbei ist, dass die dritte Farbe $F_3$ des mindestens einen ersten Punktrasters und die vierte Farbe $F_4$ des mindestens einen zweiten Punktrasters so gewählt sind, dass für den Abstand der Farbkoordinaten der Additionsfarben $F_1$' und $F_2$' gegeben durch die Formel:

$$\Delta E_{1,2} = \sqrt{(L_1^{*'} - L_2^{*'})^2 + (a_1^{*'} - a_2^{*'})^2 + (b_1^{*'} - b_2^{*'})^2}$$

die Bedingung $\Delta E_{1,2} \leq 5$ erfüllt ist.

Die Formel für $\Delta E_{1,2}$ gibt die Farbabweichung der Additionsfarben $F_1$' und $F_2$' an, wobei durch die Bedingung $\Delta E_{1,2} \leq 5$ bestimmt ist, dass die Farbabweichung eine bestimmte maximale Größe nicht überschreiten darf.

Wie der Erfinder zeigen konnte, kann durch die Bedingung $\Delta E_{1,2} \leq 5$ in vorteilhafter Weise erreicht werden, dass der Farbeindruck im Bereich der optisch aktiven Zonen und der optisch inaktiven Zonen, d.h. über das komplette Solarmodul hinweg, einen relativ geringen Kontrast und somit eine gute Farbhomogenität aufweist. Besonders vorteilhaft ist es, wenn die Farbabweichung noch kleiner ist, wobei vorzugsweise gilt: $\Delta E_{1,2} \leq 2$, insbesondere $\Delta E_{1,2} \leq 1$, und insbesondere $\Delta E_{1,2} \leq 0,5$. Grundsätzlich gilt, dass die Homogenität des Farbeindrucks des Solarmoduls immer besser wird, je kleiner die Farbabweichung ist.

Das erfindungsgemäße Solarmodul weist somit in besonders vorteilhafter Weise über das komplette Modul hinweg einen geringen Kontrast und sehr homogenen Farbeindruck auf, der sich aus den beiden Additionsfarben $F_1$' und $F_2$' ergibt, wobei sich die Additionsfarben $F_1$' und $F_2$' der optisch inaktiven Zonen und optisch aktiven Zonen nur geringfügig voneinander unterscheiden. In besonders vorteilhafter Weise zeigt der Farbeindruck des Solarmoduls hierbei keine oder nur eine geringfügige Richtungsabhängigkeit. Die Punktraster können in technisch einfacher und kostengünstiger Weise beispielsweise durch Sieb- oder Digitaldruck hergestellt werden. Vorteilhaft werden zu diesem Zweck keramische (Glas-)Farben eingesetzt, die bei der Wärmebehandlung einer aus Glas bestehenden frontseitigen Abdeckung eingebrannt werden.

Bei einer vorteilhaften Ausgestaltung der Erfindung weisen die opaken Farbpunkte des mindestens einen ersten Punktrasters und/oder des mindestens einen zweiten Punktrasters jeweils eine Größe von weniger als 5 mm, insbesondere weniger als 3 mm, insbesondere weniger 1 mm, auf. Hierdurch kann in vorteilhafter Weise erreicht werden, dass sich aus größerer Entfernung des Beobachters vom Modul von einigen Metern noch ein flächiges einfarbiges Farbbild ergibt.

Gemäß einer vorteilhaften Ausgestaltung der Erfindung weisen das mindestens eine erste Punktraster und/oder das mindestens eine zweite Punktraster jeweils eine Auflösung von mindestens 80 dpi (dots per inch) auf. Durch diese Maßnahme kann eine hohe Farbhomogenität des Solarmoduls erreicht werden. Besonders vorteilhaft ist es, wenn die opaken Farbpunkte des mindestens einen ersten Punktrasters und/oder des mindestens einen zweiten Punktrasters jeweils eine größte Abmessung von weniger 0,3 mm, insbesondere weniger als 0,2 mm, insbesondere weniger als 0,1 mm, aufweisen. Dies hat zur Folge, dass die maximale Ausdehnung der einzelnen Farbpunkte der Punktraster kleiner ist als die Auflösung des menschlichen Auges in 1 bis 2 m Entfernung von der Oberfläche des Solarmoduls (d.h. Außenfläche der lichteintrittsseitigen Abdeckung). Im Ergebnis kann eine besonders gute Farbhomogenität des Solarmoduls erreicht werden, die sehr hohen Anforderungen an die Ästhetik genügt.

Gemäß einer vorteilhaften Ausgestaltung der Erfindung besteht die lichteintrittsseitige Abdeckung aus satiniertem Glas. Diese Gläser werden durch Ätzen oder Sandstrahlen auf einer oder beiden Seiten behandelt, so dass ein hoher Anteil an diffuser Reflexion und Transmission entsteht. Durch die Verwendung von satiniertem Glas können die Punktraster teilweise verschwimmen, so dass auch bei größeren Punkten ein homogener Farbeindruck entsteht. Die diffuse Transmission lässt sich durch ein Haze-Messgerät bestimmen. Nach ASTM D1003 ist Haze das Verhältnis aus diffusem Anteil zur Gesamttransmission (oder wahlweise Reflexion). Satinierte Gläser mit einem Transmissions-Haze von größer als 50%, insbesondere größer als 80%, insbesondere größer als 90%, sind besonders geeignet einen homogeneren Farbeindruck aus dem Punktraster hinter der satinierten Frontscheibe zu erhalten.

Wie eingangs bereits ausgeführt, ist in dem erfindungsgemäßen Solarmodul der Zielkonflikt zu lösen, wonach einerseits ein homogener Farbeindruck über das komplette Solarmodul hinweg erreicht werden soll, das lichteintrittsseitige Substrat im Bereich der optisch aktiven Zonen aber genügend optische Transparenz aufweisen muss, um die photoelektrische Energiekonversion mit in der Praxis brauchbarem Wirkungsgrad zu ermöglichen. Die Zwischenabstände von einander unmittelbar benachbarten opaken Farbpunkten des mindestens einen ersten Punktrasters sind deshalb stets von Null verschieden. Gemäß einer besonders vorteilhaften Ausgestaltung der Erfindung ist das mindestens eine erste Punktraster so ausgebildet, dass ein Bedeckungsgrad der optisch aktiven Zonen weniger als 50%, vorzugsweise weniger als 25%, und noch stärker bevorzugt weniger als 10%, beträgt. Hierdurch kann einerseits eine homogene Farbwirkung, andererseits ein hoher Wirkungsgrad bzw. möglichst geringer Wirkungsgradverlust des Solarmoduls sichergestellt werden.

Der Ausdruck "Bedeckungsgrad" beschreibt den auf die Fläche der optisch aktiven Zonen bezogenen Flächenanteil der opaken Farbpunkte des mindestens einen ersten Punktrasters. Für die Berechnung des Bedeckungsgrads kann die Überdeckung der optisch aktiven Zonen durch die opaken Punkte in senkrechter Sicht durch das lichteintrittsseitige Substrat betrachtet werden. Denkbar wäre auch, die optisch aktiven Zonen in die Ebene der lichteintrittsseitigen Abdeckung, insbesondere in die Ebene des mindestens einen ersten Punktrasters, (senkrecht zur Substratfläche) zu projizieren.

Im Bereich der optisch inaktiven Zonen ist es nicht erforderlich, dass die lichteintrittsseitige Abdeckung eine hohe optische Transparenz aufweist. Vielmehr ist es vorteilhaft, wenn das mindestens eine zweite Punktraster so ausgebildet ist, dass ein Bedeckungsgrad des mindestens einen optisch inaktiven Zone, insbesondere aller optisch inaktiver Zonen, mindestens 95%, insbesondere mindestens 97%, insbesondere mindestens 99%, beträgt. Hierdurch kann in vorteilhafter Weise eine praktisch opake Abdeckung mit homogenem Farbeindruck der typischerweise sehr inhomogenen und farblich voneinander verschiedenen optisch inaktiven Zonen erreicht werden. Dies gilt insbesondere für den strukturell und farblich sehr inhomogenen Randbereich des Solarmoduls. Der Anteil der Farben der optisch inaktiven Zonen an der zweiten Additionsfarbe $F_2'$ ist somit relativ gering oder Null, so dass insgesamt eine sehr hohe Farbhomogenität über das komplette Modul erreicht werden kann.

Gemäß einer Ausgestaltung der Erfindung ist das mindestens eine zweite Punktraster so ausgebildet, dass ein Bedeckungsgrad der mindestens einen optisch inaktiven Zone, insbesondere aller optisch inaktiver Zone, 100% beträgt. Dies bedeutet, dass das zweite Punktraster ein vollflächiger Farbauftrag ohne Zwischenabstand zwischen den opaken Punkten ist. Einzelne Farbpunkte des zweiten Punktrasters sind dann nicht mehr zu erkennen. In diesem Fall entspricht die Additionsfarbe $F_2'$ mit den Farbkoordinaten $L_2^{*'}$, $a_2^{*'}$, $b_2^{*'}$ der vierten Farbe $F_4$ mit den Farbkoordinaten $L_4^*$, $a_4^*$, $b_4^*$, da eine Addition mit der Hintergrundfarbe nicht mehr möglich ist. Diese Maßnahme hat den Vorteil, dass eine sehr gute Farbhomogenität über das komplette Modul erreicht werden kann, insbesondere im strukturell und farblich inhomogenen Randbereich des Solarmoduls.

Gemäß einer hierzu alternativen Ausgestaltung der Erfindung ist es auch möglich, dass das mindestens eine zweite Punktraster so ausgebildet ist, dass ein Bedeckungsgrad des mindestens einen optisch inaktiven Zone, insbesondere aller optisch inaktiver Zone, weniger als 95% beträgt. In diesem Fall kann durch eine Anpassung der mindestens einen zweiten Additionsfarbe $F_2'$ an die erste Additionsfarbe $F_1'$ eine gute Farbhomogenität des Solarmoduls erreicht werden. Diese Ausgestaltung kann vorteilhaft sein bei Modulen mit Silizumwafern. Im Bereich zwischen den Wafern befindet sich meist eine weiße Rückseitenfolie. Diese kann durch ein zweites Punktraster mit geringerem Bedeckungsgrad überdeckt werden. Dadurch kann in diesem Bereich noch Licht eingekoppelt werden, das durch interne Reflexion und Totalreflexion bis zur Zelle gelangt.

Analog zum Bedeckungsgrad der optisch aktiven Zonen beschreibt der Ausdruck "Bedeckungsgrad" den auf die Fläche der optisch inaktiven Zonen bezogenen Flächenanteil der opaken Farbpunkte des mindestens einen zweiten Punktrasters. Für die Berechnung des Bedeckungsgrads kann die Überdeckung der optisch inaktiven Zonen durch die opaken Farbpunkte in senkrechter Sicht durch die lichteintrittsseitige Abdeckung betrachtet werden. Möglich wäre auch, die optisch inaktiven Zonen in die Ebene der lichteintrittsseitigen Abdeckung, insbesondere in die Ebene des mindestens einen zweiten Punktrasters, (senkrecht zur Substratfläche) zu projizieren.

Die Erfindung bezieht sich weiterhin auf ein Verfahren zur Herstellung eines erfindungsgemäßen Solarmoduls, wie es vorstehend beschrieben ist. Hierbei wird eine frontseitige Abdeckung des Solarmoduls bereitgestellt und auf die Außenfläche und/oder Innenfläche der frontseitigen Abdeckung aufgebracht:

- mindestens ein erstes Punktraster, welches mindestens die optisch aktiven Zonen überdeckt, wobei das erste Punktraster eine Vielzahl opaker Farbpunkte aufweist, die eine von der ersten Farbe $F_1$ verschiedene dritte Farbe $F_3$ mit den Farbkoordinaten $L^*_3$, $a^*_3$, $b^*_3$ haben, wobei sich durch Addition der ersten Farbe $F_1$ und der dritten Farbe $F_3$ eine Additionsfarbe $F_1'$ mit den Farbkoordinaten $L^*_1{}'$, $a^*_1{}'$, $b^*_1{}'$ ergibt,
- mindestens ein zweites Punktraster, welches mindestens eine optisch inaktive Zone überdeckt, wobei das zweite Punktraster eine Vielzahl opaker Farbpunkte aufweist, die eine von der zweiten Farbe $F_2$ verschiedene vierte Farbe $F_4$ mit den Farbkoordinaten $L^*_4$, $a^*_4$, $b^*_4$ haben, wobei sich durch Addition der zweiten Farbe $F_2$ und der vierten Farbe $F_4$ eine Additionsfarbe $F_2'$ mit den Farbkoordinaten $L^*_2{}'$, $a^*_2{}'$, $b^*_2{}'$ ergibt,

wobei die dritte Farbe $F_3$ und die vierte Farbe $F_4$ so gewählt sind, dass für

$$\Delta E_{1,2} = \sqrt{(L^{*'}_1 - L^{*'}_2)^2 + (a^{*'}_1 - a^{*'}_2)^2 + (b^{*'}_1 - b^{*'}_2)^2}$$

die Bedingung $\Delta E_{1,2} \leq 5$ erfüllt ist.

Das erste und/oder zweite Punktraster wird beispielsweise im Sieb- oder Digitaldruck auf das frontseitige Substrat aufgebracht. Bei einem vollflächigen Farbauftrag des mindestens einen zweiten Punktrasters kann das Punktraster auf die Außen- und/oder Innenfläche des frontseitigen Substrats beispielsweise auch aufgestrichen werden.

Des Weiteren erstreckt sich die Erfindung auf die Verwendung des erfindungsgemäßen Solarmoduls als Teil einer Gebäudehülle, insbesondere als Fenster, Fassade oder Dachbestandteil.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird nun anhand eines Ausführungsbeispiels näher erläutert, wobei Bezug auf die beigefügten Zeichnungen genommen wird. Es zeigen in vereinfachter, nicht maßstäblicher Darstellung:

Fig. 1 eine schematische Darstellung der integrierten Serienverschaltung von Solarzellen gemäß einer Ausführungsform eines in Form eines Dünnschichtsolarmoduls ausgebildeten erfindungsgemäßen Solarmoduls in einer Querschnittansicht;

Fig. 2 eine schematische Darstellung der lichteintrittsseitigen Oberfläche des Dünnschichtsolarmoduls von Fig. 1 in Aufsicht von oben;

Fig. 3 ein Ablaufdiagramm zur Veranschaulichung des erfindungsgemäßen Verfahrens.

Ausführliche Beschreibung der Zeichnungen

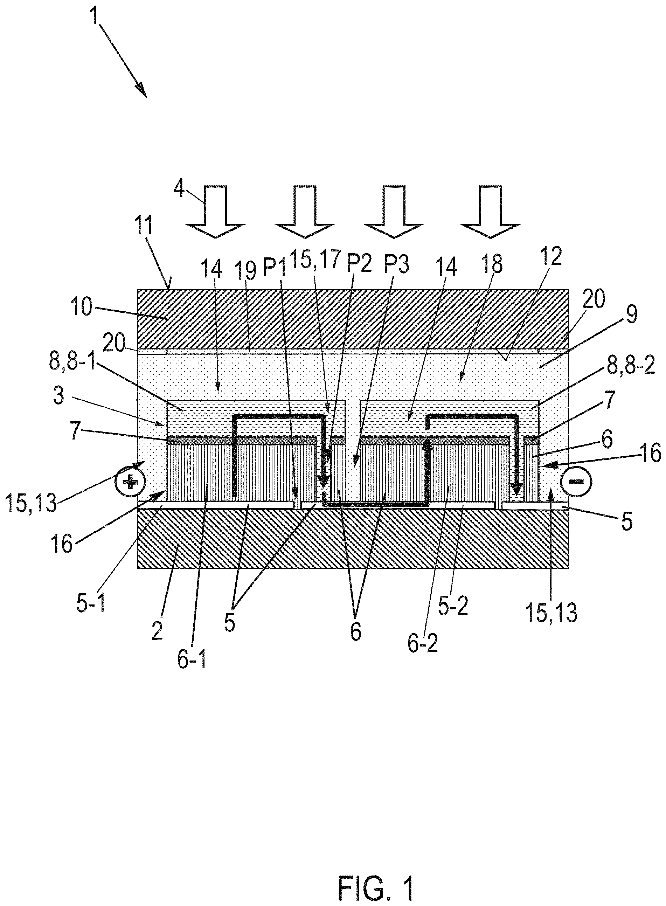

In Figur 1 ist ein insgesamt mit der Bezugszahl 1 bezeichnetes Dünnschichtsolarmodul gemäß vorliegender Erfindung in schematischer Weise anhand einer Querschnittansicht (Schnitt senkrecht zur Moduloberfläche) veranschaulicht. Das Dünnschichtsolarmodul 1 umfasst eine Mehrzahl von in integrierter Form seriell miteinander verschalteter Solarzellen 16, wobei in stark vereinfachter Weise nur zwei Solarzellen 16 dargestellt sind. Es versteht sich, dass im Dünnschichtsolarmodul 1 in aller Regel eine Vielzahl von Solarzellen 16 (beispielsweise ca. 100-150) seriell verschaltet sind.

Das Dünnschichtsolarmodul 1 weist eine Verbundscheibenstruktur in Substratkonfiguration auf. Es umfasst ein rückseitiges Substrat 2 mit einem darauf aufgebrachten Schichtenaufbau 3 aus dünnen Schichten, wobei der Schichtenaufbau 3 auf einer lichteintrittsseitigen Oberfläche des rückseitigen Substrats 2 angeordnet ist. Das rückseitige Substrat 2 ist hier beispielsweise als starre ebene Glasplatte mit einer relativ hohen Lichtdurchlässigkeit ausgebildet, wobei gleichermaßen andere elektrisch isolierende Materialien mit gewünschter Festigkeit und inertem Verhalten gegenüber den durchgeführten Prozeßschritten eingesetzt werden können.

Der Schichtenaufbau 3 umfasst eine auf der lichteintrittsseitigen Oberfläche des rückseitigen Substrats 2 angeordnete opake Rückelektrodenschicht 5, die beispielsweise aus einem lichtundurchlässigen Metall wie Molybdän (Mo) besteht und durch Aufdampfen oder magnetfeldunterstützte Kathodenzerstäubung (Sputtern) auf das rückseitige Substrat 2 aufgebracht wurde. Die Rückelektrodenschicht 5 hat beispielsweise eine Schichtdicke im Bereich von 300 nm bis 600 nm.

Auf der Rückelektrodenschicht 5 ist eine photovoltaisch aktive (opake) Absorberschicht 6 aufgebracht, die aus einem mit Metallionen dotierten Halbleiter besteht, dessen Bandabstand in der Lage ist, einen möglichst großen Anteil des Sonnenlichts zu absorbieren. Die Absorberschicht 6 besteht beispielsweise aus einem p-leitenden Chalkopyrit-Halbleiter, beispielsweise eine Verbindung der Gruppe $Cu(In/Ga)(S/Se)_2$, insbesondere Natrium(Na)-dotiertes $Cu(In/Ga)(S/Se)_2$. In vorstehender Formel können Indium (In) und Gallium (Ga) sowie Schwefel (S) und Selen (Se) wahlweise oder in Kombination vorhanden sein. Die Absorberschicht 6 hat eine Schichtdicke, die beispielsweise im Bereich von 1-5 $\mu$m liegt und insbesondere ca. 2 $\mu$m beträgt. Für die Herstellung der Absorberschicht 6 werden typischer Weise verschiedene Materiallagen beispielsweise durch Sputtern aufgebracht, die anschließend durch Erwärmen in einem Ofen, gegebenenfalls in einer S- und/oder Se-haltigen Atmosphäre, zum Verbindungshalbleiter thermisch umgesetzt werden (RTP = Rapid Thermal Processing). Dem Fachmann ist diese Art der Herstellung eines Verbindungshalbleiters wohlbekannt, so dass hier nicht näher darauf eingegangen werden muss.

Auf die Absorberschicht 6 ist eine Pufferschicht 7 abgeschieden, die hier beispielsweise aus einer Einzellage Cadmiumsulfid (CdS) und einer Einzellage aus intrinsischem Zinkoxid (i-ZnO) besteht, was in Figur 1 nicht näher dargestellt ist.

Auf die Pufferschicht 7 ist eine Frontelektrodenschicht 8 beispielsweise durch Sputtern aufgebracht. Die Frontelektrodenschicht 8 ist für Strahlung im sichtbaren Spektralbereich transparent ("Fensterelektrode"), so dass das einstrahlende Sonnenlicht 4 (in Fig. 1 durch vier parallele Pfeile veranschaulicht) nur gering geschwächt wird. Die Frontelektrodenschicht 8 basiert beispielsweise auf einem dotierten Metalloxid, beispielsweise n-leitendes Aluminium (Al)-dotiertes Zinkoxid (ZnO). Eine solche Frontelektrodenschicht 8 wird allgemein als TCO-Schicht (TCO = Transparent Conductive Oxide) bezeichnet. Die Schichtdicke der Frontelektrodenschicht 8 beträgt beispielsweise ca. 500 nm. Durch die Frontelektrodenschicht 8 wird gemeinsam mit der Pufferschicht 7 und der Absorberschicht 6 ein Heteroübergang (d.h. Abfolge von Schichten vom entgegen gesetzten Leitungstyp) gebildet. Dabei kann die Pufferschicht 7 eine elektronische Anpassung zwischen der Absorberschicht 6 und der Frontelektrodenschicht 8 bewirken.

Zum Schutz vor Umwelteinflüssen ist auf der Frontelektrodenschicht 8 eine (Kunststoff-)Klebeschicht 9 aufgebracht, die zur Verkapselung des Schichtenaufbaus 3 dient. Verklebt mit der Klebeschicht 9 ist eine für Sonnenlicht transparente front- bzw. lichteintrittsseitige Abdeckung 10, die beispielsweise in Form einer starren (ebenen) Glasplatte aus extraweißem Glas mit geringem Eisengehalt ausgebildet ist. Die frontseitige Abdeckung 10 dient zur Versiegelung und für einen mechanischen Schutz des Schichtenaufbaus 3. Die frontseitige Abdeckung 10 weist zwei einander gegenüberliegende Oberflächen auf, nämlich eine den Solarzellen 16 zugewandte Innenfläche 12 und eine von den Solarzellen 16 abgewandte Außenfläche 11, welche gleichzeitig die Moduloberfläche ist. Über die Außenfläche 11 kann das Dünnschichtsolarmodul 1 Sonnenlicht 4 aufnehmen, um an den beiden Spannungsanschlüssen (+,-) eine elektrische Spannung zu erzeugen. Ein resultierender Strompfad ist in Fig. 1 durch seriell angeordnete Pfeile veranschaulicht. Die frontseitige Abdeckung 10 und das rückseitige Substrat 2 sind durch die Klebeschicht 9 fest miteinander verbunden ("laminiert"), wobei die Klebeschicht 9 hier beispielsweise als thermoplastische Klebeschicht ausgebildet ist, die durch Erwärmen plastisch verformbar wird und beim Abkühlen die Abdeckung 10 und das Substrat 2 fest miteinander verbindet. Die Klebeschicht 9 besteht hier beispielsweise aus PVB. Die Abdeckung 10 und und das Substrat 2 mit den in die Klebeschicht 9 eingebetteten Solarzellen 16 formen gemeinsam einen laminierten Verbund.

Für die Ausbildung und Serienverschaltung der Solarzellen 16 wurde der Schichtenaufbau 3 unter Einsatz einer geeigneten Strukturierungstechnologie, beispielsweise Laserschreiben und/oder mechanische Abtragung, strukturiert. Typischer Weise werden zu diesem Zweck unmittelbare Abfolgen von jeweils drei Strukturierungslinien P1-P2-P3 in den Schichtenaufbau 3 eingebracht. Hierbei wird durch erste Strukturierungslinien P1 mindestens die Rückelektrodenschicht 5 unterteilt, wodurch die Rückelektroden 5-1, 5-2, der Solarzellen 16 erzeugt werden. Durch zweite Strukturierungslinien P2 wird mindestens die Absorberschicht 6 unterteilt, wodurch die Absorber 6-1, 6-2 der Solarzellen 16 erzeugt werden. Durch dritte Strukturierungslinien P3 wird mindestens die Frontelektrodenschicht 8 unterteilt, wodurch die Frontelektroden 8-1, 8-2 der Solarzellen 16 erzeugt werden. Über die zweiten Strukturierungslinie P2 ist die Frontelektrode 8-1 einer Solarzelle 16 mit der Rückelektrode 5-2 einer angrenzenden Solarzelle 16 elektrisch verbunden, wobei die Frontelektrode 8-1 die Rückelektrode 5-2 beispielsweise direkt kontaktiert. In dem gezeigten Ausführungsbeispiel sind die Gräben der ersten Strukturierungslinien P1 durch Material der Absorberschicht 6 verfüllt. Die Gräben der zweiten Strukturierungslinien P2 sind durch Material der Frontelektrodenschicht 8 verfüllt und die Gräben der dritten Strukturierungslinien P3 sind durch die Klebeschicht 9 verfüllt. Jede unmittelbare Abfolge aus erster, zweiter und dritter Strukturierungslinie P1-P2-P3 bildet eine Strukturierungszone 17. In Fig. 1 ist beispielhaft nur eine einzige Strukturierungszone 17 gezeigt, wodurch die Serienverschaltung zweier unmittelbar benachbarter Solarzellen 16 definiert ist, wobei im Dünnschichtsolarmodul 1 eine Vielzahl solcher Strukturierungszonen 17 zur Strukturierung und Serienverschaltung von Solarzellen 16 vorgesehen ist.

Die optischen aktiven Zonen des Dünnschichtsolarmoduls 1 sind in Figur 1 durch die Bezugszahl "14" gekennzeichnet. Dies sind jene Bereiche der Solarzellen 16, die stapelförmig übereinander liegend jeweils eine Rückelektrode, einen Absorber, sowie eine Frontelektrode aufweisen und zur photoelektrischen Konversion von Sonnenlicht 4 in elektrischen Strom fähig sind. Beispielsweise umfasst die optisch aktive Zone 14 der in Figur 1 links dargestellten Solarzelle 16 die Rückelektrode 5-1, den Absorber 6-1 und die Frontelektrode 7-1.

Das Dünnschichtsolarmodul 1 umfasst einen Innenbereich 18, welcher die Solarzellen 16 aufweist, und einen Randbereich 13. Die Solarzellen 16 im Innenbereich 18 umfassen die optisch aktiven Zonen 14 und die optisch inaktiven Strukturierungszonen 17. Der optisch inaktive Randbereich 13 umgibt den Innenbereich 18 umlaufend (vollständig). Im Randbereich 13 ist der Schichtenaufbau 3 entfernt. Der Randbereich 13 dient insbesondere zur elektrischen Kontaktierung der serienverschalteten Solarzellen 16 durch (nicht dargestellte) Sammelleiter (Busbars). In Figur 1 sind die optisch inaktiven Zonen des Dünnschichtsolarmoduls (Randbereich 13, Strukturierungszonen 17) durch die Bezugszahl "15" gekennzeichnet.

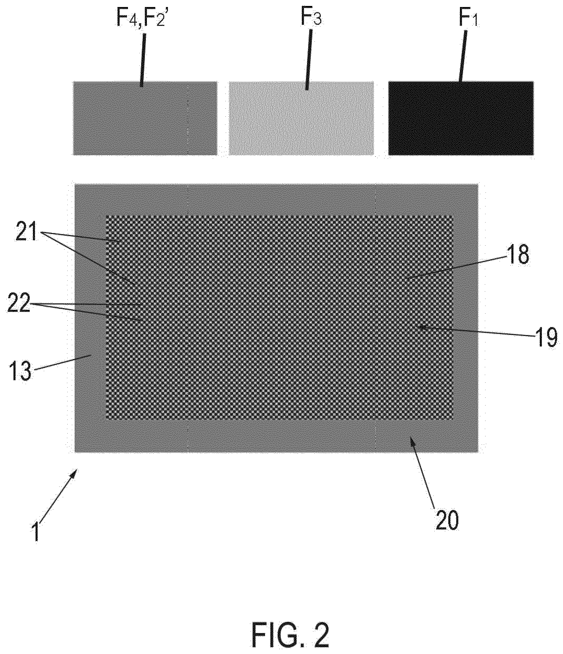

Es wird nun Bezug auf Figur 2 genommen, worin eine beispielhafte Ausgestaltung der lichteintrittsseitigen Oberfläche des Dünnschichtsolarmoduls 1 von Figur 1 schematisch veranschaulicht ist. Demnach sind auf der Innenfläche 12 der frontseitigen Abdeckung 10 ein erstes Punktraster 19 und ein zweites Punktraster 20 aufgebracht. In Sicht senkrecht durch die frontseitige Abdeckung 10, d.h. bezogen auf eine Richtung senkrecht zur Außenfläche 11, überdeckt das erste Punktraster 19 den Innenbereich 18 des Dünnschichtsolarmoduls 1 vollständig, d.h. das erste Punktraster 19 ist nur oberhalb bzw. über dem Innenbereich 18 angeordnet. Form und Abmessungen des ersten Punktrasters 19 entsprechen jenen des Innenbereichs 18. In Sicht senkrecht durch die frontseitige Abdeckung 10, d.h. bezogen auf eine Richtung senkrecht zur Außenfläche 11, überdeckt das zweite Punktraster 20 den Randbereich 13 des Dünnschichtsolarmoduls 1 vollständig, wobei das zweite Punktraster 20 nur über dem Randbereich 13 angeordnet ist. Form und Abmessungen des zweiten Punktrasters 19 entsprechen jenen des Randbereichs 13. Wie in Figur 2 angedeutet, sind das erste Punktraster 19 und das zweite Punktraster 20 jeweils von der äußeren Umgebung her durch die frontseitige transparente Abdeckung 10 hindurch erkennbar.

Das erste Punktraster 19 setzt sich aus einer Vielzahl opaker Farbpunkte 21 zusammen, die in Form eines Schachbrettmusters mit gleichen Zwischenabständen angeordnet sind. Zwischen den opaken Farbpunkten 21 befinden sich transparente Stellen 22 der frontseitigen Abdeckung 1, so dass die optisch aktiven Zonen 14 durch die frontseitige Abdeckung 1 hindurch erkennbar sind. Das erste Punktraster 19 weist eine Auflösung von mindestens 80 dpi auf, wobei die einzelnen Farbpunkte 21 jeweils eine maximale Abmessung von weniger als 0,3 mm haben. Der Bedeckungsgrad der optisch aktiven Zonen 14 durch die Farbpunkte 21 des ersten Punktrasters 19 beträgt 50% (Flächenanteil der Farbpunkte 21), d.h. bei senkrechter Sicht durch die frontseitige Abdeckung 10 bzw. (senkrechter) Projektion der optisch aktiven Zonen 14 auf die Innenfläche 11 nehmen die opaken Farbpunkte 21 des ersten Punktrasters 19 50% der Fläche der optisch aktiven Zonen 14 ein. Im übrigen Bereich der optisch aktiven Zonen 14 befinden sich transparente Stellen 22. In entsprechender Weise beträgt die optische (Semi-)Transparenz der frontseitigen Abdeckung 10 im Innenbereich 18 50%. Hierdurch kann der Wirkungsgradverlust durch Vermindern der optischen Transparenz der frontseitigen Abdeckung 10 minimiert werden.

Das zweite Punktraster 20 setzt sich in analoger Weise aus einer Vielzahl opaker Farbpunkte 21 zusammen, wobei der Bedeckungsgrad des optisch inaktiven Randbereichs 13 mindestens 95% beträgt, d.h. bei senkrechter Sicht durch die frontseitige Abdeckung 10 bzw. (senkrechter) Projektion des Randbereichs 13 auf die Innenfläche 11 nehmen die Farbpunkte 21 des zweiten Punktrasters 20 mindestens 95% der Fläche des Randbereichs 13 ein. Die Farbpunkte 21 haben einen demensprechend kleinen Zwischenabstand, so dass sie in Figur 2 nicht mehr als individuelle Farbpunkte 21 erkennbar sind. Vielmehr entspricht das zweite Punktraster 20 im Wesentlichen einem vollflächigen Farbauftrag. Dies hat zur Folge, dass der Randbereich 13 durch die frontseitige Abdeckung 10 hindurch praktisch nicht mehr erkennbar ist, wobei die optische Transparenz der frontseitigen Abdeckung 10 im Randbereich 13 maximal 5% beträgt (d.h. opake Abdeckung 10 im Randbereich 13).

In Figur 1 sind die beiden Punktraster 19, 20 (zur besseren Kenntlichmachung mit stark vergrößerter Schichtdicke des Drucks) in schematischer Weise dargestellt.

In Figur 2 sind die verschiedenen Farben des Dünnschichtsolarmoduls 1 beispielhaft anhand von Grautönen dargestellt. Die optisch aktiven Zonen 14 haben (herstellungsbedingt) eine erste Farbe $F_1$, welche durch die Farbkoordinaten $L^*_1$, $a^*_1$, $b^*_1$ definiert ist. Die opaken Farbpunkte 21 des ersten Punktrasters 19 haben eine von der ersten Farbe $F_1$ verschiedene dritte Farbe $F_3$ mit den Farbkoordinaten $L^*_3$, $a^*_3$, $b^*_3$. Da die erste Farbe $F_1$ durch die transparenten Stellen 22 hindurch sichtbar ist, addieren sich im Innenbereich 18 des Dünnschichtsolarmoduls 1 die erste Farbe $F_1$ und die dritte Farbe $F_3$ zu einer Additionsfarbe $F_1'$ mit den Farbkoordinaten $L^*_1{}'$, $a^*_1{}'$, $b^*_1{}'$. In Sicht auf die frontseitige Abdeckung 10, d.h. für einen Betrachter, welcher das Dünnschichtsolarmodul 1 von der äußeren Umgebung her betrachtet, ergibt sich somit ein Farbeindruck im Innenbereich 18, der einer Addition (additive Farbmischung) der beiden Farben $F_1$ und $F_3$ zur Additionsfarbe $F_1'$ entspricht. Es ergibt sich für den Betrachter somit ein gemittelter Farbeindruck aus der Hintergrundfarbe der optisch aktiven Zonen 14 und der Farbe der opaken Farbpunkte 21 des ersten Punktrasters 19. Die Additionsfarbe $F_1'$ kann in einfacher Weise durch ein herkömmliches Farbmeßgerät (Spektralphotometer) bestimmt werden, welches zu diesem Zweck beispielsweise mit einer Meßöffnung auf die Außenfläche 11 der frontseitigen Abdeckung 10 aufgesetzt wird. Möglich wäre auch eine Messung der Additionsfarbe $F_1'$ in einem Abstand von beispielsweise 1 bis 2 m von der Außenfläche 11. Wesentlich hierbei ist, dass für eine Addition der beiden Farben $F_1$ und $F_3$ zur Additionsfarbe $F_1'$ ein Bereich der Außenfläche 11 der frontseitigen Abdeckung 10 mit einer Größe von mindestens 0,2 cm$^2$ betrachtet wird.

Im Randbereich 13 weist das Dünnschichtsolarmodul 1 (herstellungsbedingt) eine von der ersten Farbe $F_1$ verschiedene zweite Farbe $F_2$ auf, welche durch die Farbkoordinaten $L^*_2$, $a^*_2$, $b^*_2$ definiert ist. In Figur 2 ist die zweite Farbe $F_2$ durch das im Wesentlichen vollflächig aufgebrachte zweite Punktraster 20 nicht mehr erkennbar. Die opaken Farbpunkte 21 des zweiten Punktrasters 20 haben eine von der zweiten Farbe $F_2$ verschiedene vierte Farbe $F_4$, die durch die Farbkoordinaten $L^*_4$, $a^*_4$, $b^*_4$ definiert ist. Im Randbereich 13 addieren sich somit die zweite Farbe $F_2$ und die vierte Farbe $F_4$ zu einer Additionsfarbe $F_2'$, die durch die Farbkoordinaten $L^*_4{}'$, $a^*_4{}'$, $b^*_4{}'$ definiert ist. Durch die sehr geringe optische Transparenz im Randbereich 13 entspricht die Additionsfarbe $F_2'$ im Wesentlichen der vierten Farbe $F_4$ der opaken Farbpunkte 21 des zweiten Punktrasters 20. Demnach ergibt sich in Sicht auf die frontseitige Abdeckung 10, d.h. für einen Betrachter, welcher das Dünnschichtsolarmodul 1 von der äußeren Umgebung her betrachtet, ein Farbeindruck im Randbereich 13, welcher der Additionsfarbe $F_2'$, d.h. im Wesentlichen der vierten Farbe $F_4$ der opaken Farbpunkte 21, entspricht.

Bei der Fertigung der beiden Punktraster 19, 20 sind die dritte Farbe $F_3$ und die vierte Farbe $F_4$ so gewählt, dass für den Farbabstand, gegeben durch die Formel

$$\Delta E_{1,2} = \sqrt{(L_1^{*'} - L_2^{*'})^2 + (a_1^{*'} - a_2^{*'})^2 + (b_1^{*'} - b_2^{*'})^2}$$

die Bedingung $\Delta E_{1,2} \leq 5$ erfüllt ist.

In der Praxis kann bei der Auswahl der Farben die vierte Farbe $F_4$ des zweiten Punktrasters 20 so gewählt werden, dass ein geringstmöglicher Kontrast zur dritten Farbe $F_3$ der Farbpunkte 21 des ersten Punktrasters 19 entsteht. Typischer Weise ist die vierte Farbe $F_4$ des zweiten Punktrasters 20 dunkler als die dritte Farbe $F_3$. Praktischer Weise wird von einer geeigneten deckenden vierten Farbe $F_4$ des zweiten Punktrasters 20 ausgegangen und dann eine möglichst helle dritte Farbe $F_3$ gewählt. Bei Zellflächen mit Restbuntheit sollte deren Farbton bei der Farbmischung berücksichtigt werden. Wenn die Auflösung der opaken Farbpunkte 21 relativ gering ist, dann sollte der Kontrast zwischen den dritten Farbe $F_3$ der opaken Farbpunkte 21 des ersten Punktrasters 19 und der ersten Farbe $F_1$, d.h. Hintergrundfarbe, der Zellflächen (d.h. optisch aktive Zonen 14) nicht zu groß sein, wodurch aber der erforderliche Bedeckungsgrad und damit der Wirkungsgradverlust steigen kann. Bei einer höheren Auflösung kann eine homogenere Farbanpassung auch mit stärkeren Kontrasten zwischen opaken Farbpunkten und dunkler Zellfläche erreicht werden.

Im Ausführungsbeispiel von Figur 2 verhalten sich die L*-Werte der hellen Rasterpunkte des ersten Punktrasters 19 zu den L*-Werten der Rasterpunkte des zweiten Punktrasters 20 im Randbereich 13 bei 50% Bedeckung mit schwarz wie etwa 1,4:1. Hierdurch kann ein starker Kontrast zwischen den Farben im Randbereich 13 und Innenbereich 18 vermieden werden. Der Gesamtfarbeindruck (z.B. aus 1 m Entfernung) aus opaken Farbpunkten 21 und transparenten Stellen 22 im Innenbereich 18 ist möglichst nahe am Farbeindruck der optisch inaktiven Zone 15 im Randbereich 13; d.h. die additive Farbmischung der opaken Farbpunkte 21 (Farbe $F_3$) und der Restreflexion der Zellflächen (Farbe $F_1$) ergeben eine Farbe $F_1'$, deren Helligkeit, Farbton und Sättigung jeweils weniger als 5% relativ (bevorzugt 2%, noch besser 1%) von der Helligkeit, Farbton und Sättigung der vierten Farbe F4 (entspricht im Wesentlichen der zweiten Additionsfarbe F2') über der optisch inaktiven Zone 15 im Randbereich 13 abweichen.

Für die Wahl der passenden Farben hat der Fachmann verschiedene Techniken und Methoden zur Hand, die nicht Inhalt dieser Erfindung sind. Für zwei Fälle soll dies an dieser Stelle nur beispielhaft und vereinfacht erläutert werden. Für die Berechnung der Farben soll hier der RGB-Farbraum verwendet werden. Für die Umrechnung von CIE-L*a*b* in RGB stehen Tabellen oder Programme zur Verfügung.

Fall 1: die aktive Zellfläche ist nahezu schwarz ($F_1$ in RGB = (0,0,0)) wie es bei Dünnschichtsolarmodulen auf Basis von $Cu(In,Ga)(S,Se)_2$ bei geeigneten Prozessbedingungen annähernd erreicht werden kann. Die gewünschte Farbe des Moduls $F_1$' ist Grau, beispielsweise RGB (64,64,64). Zur möglichst geringen Bedeckung mit dem ersten Punktraster muss also Weiss (256,256,256) als Farbe $F_3$ verwendet werden. Der Bedeckungsgrad des ersten Punktrasters errechnet sich damit zu 25%. Für die Randabdeckung kann dann bei 100% Bedeckung des zweiten Punktrasters die Farbe $F_4=F_2'=F_1'$= (64,64,64) gewählt werden.

Fall 2: ein Kunde wünscht ein blaues Modul mit dem RGB Farbcode (0,50,114). Die aktive Fläche ist schwarz (RGB 0,0,0). Die Randabdeckung soll wegen der metallischen Kontaktbänder möglichst opak sein, also ein Bedeckungsgrad von 100% ist erwünscht für das zweite Punktraster. Um in der aktiven Zellfläche eine möglichst geringe Bedeckung zu erreichen, muss die Farbe $F_3$ der Punkte des ersten Rasters einen möglichst hellen Farbton haben. Helligkeit und Sättigung der Farbe dürfen sich aber nicht ändern. Limitierend ist die hellste Farbkoordinate, hier in RGB also Blau (114). Maximaler Blauwert ist 256 im RGB Farbraum. Die maximale Bedeckung ist also 114/256= 44%. Für den RGB Farbcode der Farbe $F_3$ der Einzelpunkte erhält man dann F3=(0,113,256)

Obgleich dies im Ausführungsbeispiel von Figur 2 nicht gezeigt ist, wäre es gleichermaßen möglich, im Bereich der Strukturierungszonen 17 jeweils ein die Strukturierungszone 17 (vollständig) überdeckendes zweites Punktraster 20 vorzusehen. Hierdurch kann die Farbhomogenität des Dünnschichtsolarmoduls 1 noch weiter verbessert werden.

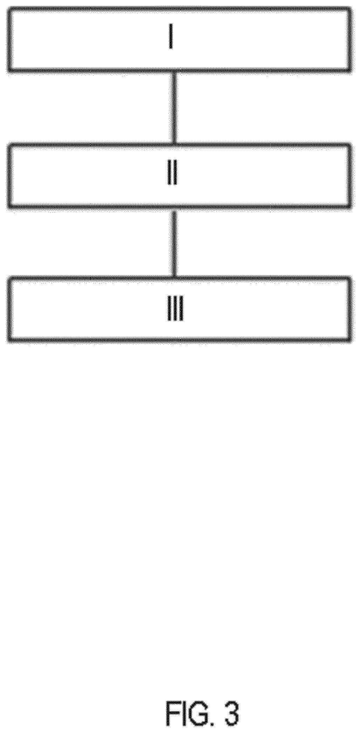

Es wird nun Bezug auf Figur 3 genommen, worin ein Ausführungsbeispiel des erfindungsgemäßen Verfahrens veranschaulicht ist. Das Verfahren umfasst einen ersten Schritt I, bei dem eine frontseitige Abdeckung 10 mit einer der äußeren Umgebung zugewandten Außenfläche 11 und einer den Solarzellen 16 zugewandten Innenfläche 12 bereitgestellt wird. In einem zweiten Schritt II wird mindestens ein erstes Punktraster 19, welches mindestens die optisch aktiven Zonen 14 der Solarzellen 16 überdeckt, auf die Innenfläche 12 und/oder Außenfläche 11 der frontseitigen Abdeckung 10 aufgebracht. Das erste Punktraster 19 weist eine Vielzahl opaker Farbpunkte 21 auf, die eine von der ersten Farbe $F_1$ der optisch aktiven Zonen 14 verschiedene dritte Farbe $F_3$ mit den Farbkoordinaten $L*_3$, $a*_3$, $b*_3$ haben, wobei sich durch Addition der ersten Farbe $F_1$ und der dritten Farbe $F_3$ eine Additionsfarbe $F_1$' mit den Farbkoordinaten $L*_1'$, $a*_1'$, $b*_1'$ ergibt. In einem dritten Schritt III wird mindestens ein zweites Punktraster 20, welches die optisch inaktiven Zonen 15 überdeckt, auf die Innenfläche 12 und/oder Außenfläche 11 der leichteintrittsseitigen Abdeckung 10 aufgebracht. Das zweite Punktraster 2 weist eine Vielzahl opaker Farbpunkte 21 auf, die eine von der zweiten Farbe $F_2$ verschiedene vierte Farbe $F_4$ mit den Farbkoordinaten $L*_4$, $a*_4$, $b*_4$ haben, wobei sich durch Addition der zweiten Farbe $F_2$ und der vierten Farbe $F_4$ eine Additionsfarbe $F_2$' mit den Farbkoordinaten $L*_2'$, $a*_2'$, $b*_2'$ ergibt. Die dritte Farbe $F_3$ und die vierte Farbe $F_4$ sind so gewählt, dass für den Farbabstand

$$\Delta E_{1,2} = \sqrt{(L_1^{*'} - L_2^{*'})^2 + (a_1^{*'} - a_2^{*'})^2 + (b_1^{*'} - b_2^{*'})^2}$$

die Bedingung $\Delta E_{1,2} \leq 5$ erfüllt ist.

Das erste Punktraster 19 und das zweite Punktraster 20 werden beispielsweise im Sieb- oder Digitaldruckverfahren auf der frontseitigen Abdeckung 10 aufgebracht.

Die Erfindung stellt ein verbessertes Solarmodul sowie ein Verfahren zu dessen Herstellung zur Verfügung, welches einen einen starken Kontrast zwischen optisch aktiven und optisch inaktiven Zonen vermeidet. In vorteilhafter Weise vermittelt das Solarmodul einen sehr homogenen Farbeindruck über das komplette Modul hinweg, bei geringer oder fehlender Richtungsabhängigkeit des Farbeindrucks. Durch den relativ geringen Belegungsgrad des mindestens einen Punktrasters im Innenbereich des Solarmoduls kann der Wirkungsgradverlust des Solarmoduls minimiert werden.

Bezugszeichenliste

| 1 | Dünnschichtsolarmodul |
|---|---|
| 2 | rückseitiges Substrat |
| 3 | Schichtenaufbau |
| 4 | Sonnenlicht |
| 5 | Rückelektrodenschicht |
| 5-1, 5-2 | Rückelektrode |

| 6 | Absorberschicht |
|---|---|
| 6-1, 6-2 | Absorber |
| 7 | Pufferschicht |
| 8 | Frontelektrodenschicht |
| 8-1, 8-2 | Frontelektrode |
| 9 | Klebeschicht |
| 10 | frontseitige Abdeckung |
| 11 | Außenfläche |
| 12 | Innenfläche |
| 13 | Randbereich |
| 14 | optisch aktive Zone |
| 15 | optisch inaktive Zone |
| 16 | Solarzelle |
| 17 | Strukturierungszone |
| 18 | Innenbereich |
| 19 | erstes Punktraster |
| 20 | zweites Punktraster |
| 21 | Farbpunkt |
| 22 | transparente Stelle |

**Patentansprüche**

1. Solarmodul (1) mit Solarzellen (16) zur photovoltaischen Energieerzeugung, umfassend:

   - eine frontseitige Abdeckung (10) mit einer der äußeren Umgebung zugewandten Außenfläche (11) und einer den Solarzellen (16) zugewandten Innenfläche (12),
   - optisch aktive Zonen (14), die eine erste Farbe $F_1$ mit den Farbkoordinaten $L^*_1$, $a^*_1$, $b^*_1$ haben,
   - optisch inaktive Zonen (15), die mindestens eine von der ersten Farbe $F_1$ verschiedene zweite Farbe $F_2$ mit den Farbkoordinaten $L^*_2$, $a^*_2$, $b^*_2$ haben, **dadurch gekennzeichnet, dass** die frontseitige Abdeckung (10) auf ihrer Außen- und/oder Innenfläche aufweist:
   - mindestens ein erstes Punktraster (19), welches mindestens die optisch aktiven Zonen (14) überdeckt, wobei das erste Punktraster (19) eine Vielzahl opaker Farbpunkte aufweist, die eine von der ersten Farbe $F_1$ verschiedene dritte Farbe $F_3$ mit den Farbkoordinaten $L^*_3$, $a^*_3$, $b^*_3$ haben, wobei sich durch Addition der ersten Farbe $F_1$ und der dritten Farbe $F_3$ eine Additionsfarbe $F_1'$ mit den Farbkoordinaten $L^*_1{}'$, $a^*_1{}'$, $b^*_1{}'$ ergibt,
   - mindestens ein zweites Punktraster (20), welches mindestens eine optisch inaktive Zone (15) überdeckt, wobei das zweite Punktraster (20) eine Vielzahl opaker Farbpunkte (21) aufweist, die eine von der zweiten Farbe $F_2$ verschiedene vierte Farbe $F_4$ mit den Farbkoordinaten $L^*_4$, $a^*_4$, $b^*_4$ haben, wobei sich durch Addition der zweiten Farbe $F_2$ und der vierten Farbe $F_4$ eine Additionsfarbe $F_2'$ mit den Farbkoordinaten $L^*_2{}'$, $a^*_2{}'$, $b^*_2{}'$ ergibt,

   wobei die dritte Farbe $F_3$ und die vierte Farbe $F_4$ so gewählt sind, dass für die Farbabweichung

$$\Delta E_{1,2} = \sqrt{(L_1^{*'} - L_2^{*'})^2 + (a_1^{*'} - a_2^{*'})^2 + (b_1^{*'} - b_2^{*'})^2}$$

   die Bedingung $\Delta E_{1,2} \leq 5$ erfüllt ist.

2. Solarmodul (1) nach Anspruch 1, bei welchem die dritte Farbe $F_3$ und die vierte Farbe $F_4$ so gewählt sind, dass für die Farbabweichung $\Delta E_{1,2}$ die Bedingung $\Delta E_{1,2} \leq 2$, insbesondere $\Delta E_{1,2} \leq 1$, insbesondere $\Delta E_{1,2} \leq 0,5$ erfüllt ist.

3. Solarmodul (1) nach einem der Ansprüche 1 oder 2, bei welchem die opaken Farbpunkte (21) des mindestens einen ersten Punktrasters (19) und/oder des mindestens einen zweiten Punktrasters (20) jeweils eine Größe von weniger als 5 mm, insbesondere weniger als 3 mm, insbesondere weniger 1 mm, aufweisen.

4. Solarmodul (1) nach einem der Ansprüche 1 bis 3, bei welchem das mindestens eine erste Punktraster (19) und/oder das mindestens eine zweite Punktraster (20) jeweils eine Auflösung von mindestens 80 dpi aufweisen und wobei die opaken Farbpunkte (21) des ersten Punktrasters (19) und/oder zweiten Punktrasters (20) jeweils eine größte Abmessung von weniger 0,3 mm, insbesondere weniger als 0,2 mm, insbesondere weniger als 0,1 mm, aufweisen.

5.  Solarmodul (1) nach einem der Ansprüche 1 bis 4, bei welchem das mindestens eine erste Punktraster (19) so ausgebildet ist, dass ein Bedeckungsgrad der optisch aktiven Zonen (14) weniger als 50%, insbesondere weniger als 25%, insbesondere weniger als 10%, beträgt.

6.  Solarmodul (1) nach einem der Ansprüche 1 bis 5, bei welchem das mindestens eine zweite Punktraster (20) so ausgebildet ist, dass ein Bedeckungsgrad des mindestens einen optisch inaktiven Zone (15), insbesondere aller optisch inaktiver Zonen (15), mindestens 95%, insbesondere mindestens 97%, insbesondere mindestens 99%, beträgt.

7.  Solarmodul (1) nach einem der Ansprüche 1 bis 6, bei welchem das mindestens eine zweite Punktraster (20) so ausgebildet ist, dass ein Bedeckungsgrad des mindestens einen optisch inaktiven Zone (15), insbesondere aller optisch inaktiver Zonen (15), 100% beträgt, wobei die Additionsfarbe $F_2$' mit den Farbkoordinaten $L^*_2$', $a^*_2$', $b^*_2$' der vierten Farbe $F_4$ mit den Farbkoordinaten $L^*_4$, $a^*_4$, $b^*_4$ entspricht.

8.  Solarmodul (1) nach einem der Ansprüche 1 bis 5, bei welchem das mindestens eine zweite Punktraster (20) so ausgebildet ist, dass ein Bedeckungsgrad des mindestens einen optisch inaktiven Zone (15), insbesondere aller optisch inaktiver Zonen (15), weniger als 95% beträgt.

9.  Solarmodul (1) nach einem der Ansprüche 1 bis 8, bei welchem das mindestens eine erste Punktraster (19) einen Innenbereich (18) des Solarmoduls (1) überdeckt.

10. Solarmodul (1) nach einem der Ansprüche 1 bis 9, bei welchem das mindestens eine zweite Punktraster (20) eine optisch inaktive Randzone (13) des Solarmoduls (1) überdeckt.

11. Solarmodul (1) nach einem der Ansprüche 1 bis 10, bei welchem optisch inaktive Zonen (15) im Innenbereich (18) jeweils von einem zweiten Punktraster (20) überdeckt sind.

12. Solarmodul (1) nach einem der Ansprüche 1 bis 11, bei welchem das mindestens eine erste Punktraster (19) und das mindestens eine zweite Punkraster (20) auf der Innenfläche (12) der frontseitigen Abdeckung (1) angeordnet sind.

13. Solarmodul (1) nach einem der Ansprüche 1 bis 12, bei welchem die frontseitige Abdeckung (10) aus satiniertem Glas besteht mit einem Haze-Wert von größer als 50%, insbesondere größer als 80%, insbesondere größer als 90%.

14. Verfahren zur Herstellung eines Solarmoduls (1) mit Solarzellen zur photovoltaischen Energieerzeugung nach einem der Ansprüche 1 bis 13, bei welchem eine frontseitige Abdeckung (10) mit einer der äußeren Umgebung zugewandten Außenfläche (11) und einer den Solarzellen (16) zugewandten Innenfläche (12) bereitgestellt wird, wobei optisch aktive Zonen (14) der Solarzellen (16) eine erste Farbe $F_1$ mit den Farbkoordinaten $L^*_1$, $a^*_1$, $b^*_1$ haben, und optisch inaktive Zonen (15) mindestens eine von der ersten Farbe $F_1$ verschiedene zweite Farbe $F_2$ mit den Farbkoordinaten $L^*_2$, $a^*_2$, $b^*_2$ haben, **dadurch gekennzeichnet, dass** auf die Außenfläche (11) und/oder die Innenfläche (12) der frontseitigen Abdeckung (10) aufgebracht wird:

  - mindestens ein erstes Punktraster (19), welches mindestens die optisch aktiven Zonen (14) überdeckt, wobei das erste Punktraster (19) eine Vielzahl opaker Farbpunkte (21) aufweist, die eine von der ersten Farbe $F_1$ verschiedene dritte Farbe $F_3$ mit den Farbkoordinaten $L^*_3$, $a^*_3$, $b^*_3$ haben, wobei sich durch Addition der ersten Farbe $F_1$ und der dritten Farbe $F_3$ eine Additionsfarbe $F_1$' mit den Farbkoordinaten $L^*_1$', $a^*_1$', $b^*_1$' ergibt,
  - mindestens ein zweites Punktraster (20), welches mindestens eine optisch inaktive Zone (15) überdeckt, wobei das zweite Punktraster (20) eine Vielzahl opaker Farbpunkte (21) aufweist, die eine von der zweiten Farbe $F_2$ verschiedene vierte Farbe $F_4$ mit den Farbkoordinaten $L^*_4$, $a^*_4$, $b^*_4$ haben, wobei sich durch Addition der zweiten Farbe $F_2$ und der vierten Farbe $F_4$ eine Additionsfarbe $F_2$' mit den Farbkoordinaten $L^*_2$', $a^*_2$', $b^*_2$' ergibt,

wobei die dritte Farbe $F_3$ und die vierte Farbe $F_4$ so gewählt sind, dass für die Farbabweichung

$$\Delta E_{1,2} = \sqrt{(L_1^{*'} - L_2^{*'})^2 + (a_1^{*'} - a_2^{*'})^2 + (b_1^{*'} - b_2^{*'})^2}$$

die Bedingung $\Delta E_{1,2} \leq 5$ erfüllt ist.

**15.** Verwendung des Solarmoduls nach einem der Ansprüche 1 bis 13 als Teil einer Gebäudehülle, insbesondere als Fenster, Fassade oder Dachbestandteil.

**Claims**

**1.** Solar module (1) with solar cells (16) for photovoltaic energy generation, comprising:

- a front covering (10) with an outer surface (11) facing the external surroundings and an inner surface (12) facing the solar cells (16),
- optically active zones (14) that have a first color $F_1$ having the color coordinates $L^*_1$, $a^*_1$, $b^*_1$,
- optically inactive zones (15) that have at least one second color $F_2$ different from the first color $F_1$ and having the color coordinates $L^*_2$, $a^*_2$, $b^*_2$,

**characterized in that** the front covering (10) has on its outer and/or inner surface:

- at least one first dot grid (19) that covers at least the optically active zones (14), wherein the first dot grid (19) has a large number of opaque colored dots that have a third color $F_3$ different from the first color $F_1$ and having the color coordinates $L^*_3$, $a^*_3$, $b^*_3$, wherein addition of the first color $F_1$ and the third color $F_3$ yields an additive color $F_1'$ having the color coordinates $L^*_1{}'$, $a^*_1{}'$, $b^*_1{}'$,
- at least one second dot grid (20) that covers at least one optically inactive zone (15), wherein the second dot grid (20) has a plurality of opaque colored dots (21) that have a fourth color $F_4$ different from the second color $F_2$ and having the color coordinates $L^*_4$, $a^*_4$, $b^*_4$, wherein addition of the second color $F_2$ and the fourth color $F_4$ yields an additive color $F_2'$ having the color coordinates $L^*_2{}'$, $a^*_2{}'$, $b^*_2{}'$,

wherein the third color $F_3$ and the fourth color $F_4$ are selected such that for the color deviation

$$\Delta E_{1,2} = \sqrt{(L_1^{*'} - L_2^{*'})^2 + (a_1^{*'} - a_2^{*'})^2 + (b_1^{*'} - b_2^{*'})^2}$$

the condition $\Delta E_{1,2} \leq 5$ is satisfied.

**2.** Solar module (1) according to claim 1, wherein the third color $F_3$ and the fourth color $F_4$ are selected such that for the color deviation $\Delta E_{1,2}$ the condition $\Delta E_{1,2} \leq 2$, in particular $\Delta E_{1,2} \leq 1$, in particular $\Delta E_{1,2} \leq 0.5$ is satisfied.

**3.** Solar module (1) according to one of claims 1 or 2, wherein the opaque colored dots (21) of the at least one first dot grid (19) and/or of the at least one second dot grid (20) respectively have a size of less than 5 mm, in particular less than 3 mm, in particular less than 1 mm.

**4.** Solar module (1) according to one of claims 1 through 3, wherein the at least one first dot grid (19) and/or the at least one second dot grid (20) respectively have a resolution of at least 80 dpi and wherein the opaque colored dots (21) of the first dot grid (19) and/or second dot grid (20) have in each case a maximum dimension of less than 0.3 mm, in particular less than 0.2 mm, in particular less than 0.1 mm.

**5.** Solar module (1) according to one of claims 1 through 4, wherein the at least one first dot grid (19) is implemented such that a degree of coverage of the optically active zones (14) is less than 50%, in particular less than 25%, in particular less than 10%.

**6.** Solar module (1) according to one of claims 1 through 5, wherein the at least one second dot grid (20) is implemented such that a degree of coverage of the at least one optically inactive zone (15), in particular of all optically inactive zones (15), is at least 95%, in particular at least 97%, in particular at least 99%.

**7.** Solar module (1) according to one of claims 1 through 6, wherein the at least one second dot grid (20) is implemented such that a degree of coverage of the at least one optically inactive zone (15), in particular of all optically inactive zones (15), is 100%, wherein the additive color $F_2'$ having the color coordinates $L^*_2{}'$, $a^*_2{}'$, $b^*_2{}'$ corresponds to the

**EP 3 531 458 B1**

fourth color $F_4$ having the color coordinates $L^*_4$, $a^*_4$, $b^*_4$.

8.  Solar module (1) according to one of claims 1 through 5, wherein the at least one second dot grid (20) is implemented such that a degree of coverage of the at least one optically inactive zone (15), in particular of all optically inactive zones (15), is less than 95%.

9.  Solar module (1) according to one of claims 1 through 8, wherein the at least one first dot grid (19) covers an inner region (18) of the solar module (1).

10. Solar module (1) according to one of claims 1 through 9, wherein the at least one second dot grid (20) covers an optically inactive edge zone (13) of the solar module (1).

11. Solar module (1) according to one of claims 1 through 10, wherein optically inactive zones (15) in the inner region (18) are respectively covered by a second dot grid (20).

12. Solar module (1) according to one of claims 1 through 11, wherein the at least one first dot grid (19) and the at least one second dot grid (20) are arranged on the inner surface (12) of the front covering (1).

13. Solar module (1) according to one of claims 1 through 12, wherein the front covering (10) is made of satinized glass with a haze value greater than 50%, in particular greater than 80%, in particular greater than 90%.

14. Method for producing a solar module (1) with solar cells for photovoltaic energy generation according to one of claims 1 through 13, wherein a front covering (10) with an outer surface (11) facing the external surroundings and an inner surface (12) facing the solar cells (16) is provided, wherein optically active zones (14) of the solar cells (16) have a first color $F_1$ having the color coordinates $L^*_1$, $a^*_1$, $b^*_1$, and optically inactive zones (15) have at least one second color $F_2$ different from the first color $F_1$ and having the color coordinates $L^*_2$, $a^*_2$, $b^*_2$, **characterized in that** on the outer surface (11) and/or the inner surface (12) of the front covering (10) is applied:

    - at least one first dot grid (19) that covers at least the optically active zones (14), wherein the first dot grid (19) has a large number of opaque colored dots (21) that have a third color $F_3$ different from the first color $F_1$ and having the color coordinates $L^*_3$, $a^*_3$, $b^*_3$, wherein addition of the first color $F_1$ and of the third color $F_3$ yields an additive color $F_1'$ having the color coordinates $L^*_1{}'$, $a^*_1{}'$, $b^*_1{}'$,
    - at least one second dot grid (20) that covers at least one optically inactive zone (15), wherein the second dot grid (20) has a large number of opaque colored dots (21), that have a fourth color $F_4$ different from the second color $F_2$ with and having the color coordinates $L^*_4$, $a^*_4$, $b^*_4$, wherein addition of the second color $F_2$ and the fourth color $F_4$ yields an additive color $F_2'$ having the color coordinates $L^*_2{}'$, $a^*_2{}'$, $b^*_2{}'$,

    wherein the third color $F_3$ and the fourth color $F_4$ are selected such that for the color deviation

    $$\Delta E_{1,2} = \sqrt{(L_1^{*'} - L_2^{*'})^2 + (a_1^{*'} - a_2^{*'})^2 + (b_1^{*'} - b_2^{*'})^2}$$

    the condition $\Delta E_{1,2} \leq 5$ is satisfied.

15. Use of the solar module according to one of claims 1 through 13 as part of a building envelope, in particular as a window, façade, or roof component.


**Revendications**

1.  Module solaire (1) avec cellules solaires (16) pour la production d'énergie photovoltaïque, comprenant :

    - un revêtement frontal (10) avec une surface extérieure (11) tournée vers l'environnement extérieur et une surface intérieure (12) tournée vers les cellules solaires (16),
    - les zones optiquement actives (14) qui ont une première couleur $F_1$ ayant les coordonnées de couleur $L^*_1$, $a^*_1$, $b^*_1$,
    - les zones optiquement inactives (15) qui ont au moins une deuxième couleur F2 différente de la première

couleur $F_1$ et ayant les coordonnées de couleur $L^*_2$, $a^*_2$, $b^*_2$,

**caractérisé en ce que** le revêtement frontal (10) présente sur sa surface extérieure et/ou intérieure :

- au moins une première grille de points (19) qui couvre au moins les zones optiquement actives (14), la première grille de points (19) présentant un grand nombre de points colorés opaques qui ont une troisième couleur $F_3$ différente de la première couleur $F_1$ et ayant les coordonnées de couleur $L^*_3$, $a^*_3$, $b^*_3$, l'addition de la première couleur $F_1$ et de la troisième couleur $F_3$ donnant une couleur additive $F_1'$ ayant les coordonnées de couleur $L^*_1'$, $a^*_1'$, $b^*_1'$,
- au moins une deuxième grille de points (20) qui couvre au moins une zone optiquement inactive (15), dans laquelle la deuxième grille de points (20) présente une pluralité de points colorés opaques (21) qui ont une quatrième couleur $F_4$ différente de la deuxième couleur $F_2$ et ayant les coordonnées de couleur $L^*_4$, $a^*_4$, $b^*_4$, dans laquelle l'addition de la deuxième couleur $F_2$ et de la quatrième couleur $F_4$ donne une couleur additive $F_2'$ ayant les coordonnées de couleur $L^*_2'$, $a^*_2'$, $b^*_2'$,

dans laquelle la troisième couleur $F_3$ et la quatrième couleur $F_4$ sont choisies de telle sorte que pour l'écart de couleur

$$\Delta E_{1,2} = \sqrt{(L_1^{*'} - L_2^{*'})^2 + (a_1^{*'} - a_2^{*'})^2 + (b_1^{*'} - b_2^{*'})^2}$$

la condition $\Delta E_{1,2} \leq 5$ est remplie.

2. Module solaire (1) selon la revendication 1, dans lequel la troisième couleur $F_3$ et la quatrième couleur $F_4$ sont choisies de telle sorte que pour l'écart de couleur $\Delta E_{1,2}$ la condition $\Delta E_{1,2} \leq 2$, en particulier $\Delta E_{1,2} \leq 1$, en particulier $\Delta E_{1,2} \leq 0,5$ est satisfaite.

3. Module solaire (1) selon l'une des revendications 1 ou 2, dans lequel les points colorés opaques (21) de la au moins une première grille de points (19) et/ou de la au moins une deuxième grille de points (20) ont respectivement une taille inférieure à 5 mm, en particulier inférieure à 3 mm, en particulier inférieure à 1 mm.

4. Module solaire (1) selon l'une des revendications 1 à 3, dans lequel l'au moins une première grille de points (19) et/ou l'au moins une deuxième grille de points (20) présentent respectivement une résolution d'au moins 80 dpi et dans lequel les points colorés opaques (21) de la première grille de points (19) et/ou de la deuxième grille de points (20) présentent respectivement une dimension maximale inférieure à 0,3 mm, en particulier inférieure à 0,2 mm, en particulier inférieure à 0,1 mm.

5. Module solaire (1) selon l'une des revendications 1 à 4, dans lequel la au moins une première grille de points (19) est réalisée de telle sorte qu'un degré de couverture des zones optiquement actives (14) est inférieur à 50 %, en particulier inférieur à 25 %, en particulier inférieur à 10 %.

6. Module solaire (1) selon l'une des revendications 1 à 5, dans lequel la au moins une deuxième grille de points (20) est réalisée de telle sorte qu'un degré de couverture de la au moins une zone optiquement inactive (15), en particulier de toutes les zones optiquement inactives (15), est d'au moins 95 %, en particulier d'au moins 97 %, en particulier d'au moins 99 %.

7. Module solaire (1) selon l'une des revendications 1 à 6, dans lequel la au moins une deuxième grille de points (20) est réalisée de telle sorte qu'un degré de couverture de la au moins une zone optiquement inactive (15), en particulier de toutes les zones optiquement inactives (15), est de 100 %, dans lequel la couleur additive $F_2'$ ayant les coordonnées de couleur $L^*_2'$, $a^*_2'$, $b^*_2'$ correspond à la quatrième couleur $F_4$ ayant les coordonnées de couleur $L^*_4$, $a^*_4$, $b^*_4$.

8. Module solaire (1) selon l'une des revendications 1 à 5, dans lequel la au moins une deuxième grille de points (20) est réalisée de telle sorte qu'un degré de couverture de la au moins une zone optiquement inactive (15), en particulier de toutes les zones optiquement inactives (15), est inférieur à 95%.

9. Module solaire (1) selon l'une des revendications 1 à 8, dans lequel la au moins une première grille de points (19) couvre une zone intérieure (18) du module solaire (1).

**10.** Module solaire (1) selon l'une des revendications 1 à 9, dans lequel la au moins une deuxième grille de points (20) couvre une zone de bord optiquement inactive (13) du module solaire (1).

**11.** Module solaire (1) selon l'une des revendications 1 à 10, dans lequel des zones optiquement inactives (15) dans la zone intérieure (18) sont respectivement couvertes par une deuxième grille de points (20).

**12.** Module solaire (1) selon l'une des revendications 1 à 11, dans lequel l'au moins une première grille de points (19) et l'au moins une deuxième grille de points (20) sont disposées sur la surface intérieure (12) de la couverture frontale (1).

**13.** Module solaire (1) selon l'une des revendications 1 à 12, dans lequel le revêtement frontal (10) est constitué de verre satiné avec une valeur de trouble supérieure à 50 %, en particulier supérieure à 80 %, en particulier supérieure à 90 %.

**14.** Procédé de fabrication d'un module solaire (1) avec des cellules solaires pour la production d'énergie photovoltaïque selon l'une des revendications 1 à 13, dans lequel il est prévu un revêtement frontal (10) avec une surface extérieure (11) tournée vers l'environnement extérieur et une surface intérieure (12) tournée vers les cellules solaires (16), dans lequel les zones optiquement actives (14) des cellules solaires (16) ont une première couleur $F_1$ ayant les coordonnées de couleur $L^*_1$, $a^*_1$, $b^*_1$, et les zones optiquement inactives (15) ont au moins une deuxième couleur $F_2$ différente de la première couleur $F_1$ et ayant les coordonnées de couleur $L^*_2$, $a^*_2$, $b^*_2$, **caractérisé en ce que** sur la surface extérieure (11) et/ou la surface intérieure (12) du revêtement frontal (10) est appliqué :

- au moins une première grille de points (19) qui couvre au moins les zones optiquement actives (14), la première grille de points (19) présentant un grand nombre de points colorés opaques (21) qui ont une troisième couleur $F_3$ différente de la première couleur $F_1$ et ayant les coordonnées de couleur $L^*_3$, $a^*_3$, $b^*_3$, l'addition de la première couleur $F_1$ et de la troisième couleur $F_3$ donnant une couleur additive $F_1'$ ayant les coordonnées de couleur $L^*_1{}'$, $a^*_1{}'$, $b^*_1{}'$,
- au moins une deuxième grille de points (20) qui couvre au moins une zone optiquement inactive (15), dans laquelle la deuxième grille de points (20) présente un grand nombre de points colorés opaques (21), qui ont une quatrième couleur $F_4$ différente de la deuxième couleur $F_2$ avec et ayant les coordonnées de couleur $L^*_4$, $a^*_4$, $b^*_4$, dans laquelle l'addition de la deuxième couleur $F_2$ et de la quatrième couleur $F_4$ donne une couleur additive $F_2'$ ayant les coordonnées de couleur $L^*_2{}'$, $a^*_2{}'$, $b^*_2{}'$,

dans laquelle la troisième couleur $F_3$ et la quatrième couleur $F_4$ sont choisies de telle sorte que pour l'écart de couleur

$$\Delta E_{1,2} = \sqrt{(L_1^{*'} - L_2^{*'})^2 + (a_1^{*'} - a_2^{*'})^2 + (b_1^{*'} - b_2^{*'})^2}$$

la condition $\Delta E_{1,2} \leq 5$ est remplie.

**15.** Utilisation du module solaire selon l'une des revendications 1 à 13 comme partie d'une enveloppe de bâtiment, en particulier comme élément de fenêtre, de façade ou de toit.

FIG. 1

EP 3 531 458 B1

FIG. 2

20

```
┌─────────────────────────────────┐
│                                 │
│               I                 │
│                                 │
└─────────────────────────────────┘
                 │
┌─────────────────────────────────┐
│                                 │
│               II                │
│                                 │
└─────────────────────────────────┘
                 │
┌─────────────────────────────────┐
│                                 │
│              III                │
│                                 │
└─────────────────────────────────┘
```

FIG. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2007071703 A1
- WO 2014045142 A1
- WO 2011036209 A1
- CH 678466 A5
- DE 10349269